(19) Europäisches Patentamt
European Patent Office
Office européen des brevets

(11) EP 3 442 043 A1

(12) **EUROPEAN PATENT APPLICATION**
published in accordance with Art. 153(4) EPC

(43) Date of publication:
**13.02.2019 Bulletin 2019/07**

(21) Application number: **17779044.1**

(22) Date of filing: **30.03.2017**

(51) Int Cl.:
***H01L 51/05*** *(2006.01)*
***C08G 61/12*** *(2006.01)*
***H01L 29/786*** *(2006.01)*
***H01L 51/30*** *(2006.01)*

(86) International application number:
**PCT/JP2017/013390**

(87) International publication number:
**WO 2017/175665 (12.10.2017 Gazette 2017/41)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **07.04.2016 JP 2016077035**

(71) Applicant: **FUJIFILM Corporation**
**Tokyo 106-8620 (JP)**

(72) Inventor: **TAMAKUNI, Fumiko**
**Ashigarakami-gun**
**Kanagawa 258-8577 (JP)**

(74) Representative: **Hoffmann Eitle**
**Patent- und Rechtsanwälte PartmbB**
**Arabellastraße 30**
**81925 München (DE)**

# (54) ORGANIC THIN FILM TRANSISTOR ELEMENT, COMPOSITION FOR FORMING ORGANIC SEMICONDUCTOR FILM, METHOD FOR PRODUCING ORGANIC SEMICONDUCTOR FILM, AND ORGANIC SEMICONDUCTOR FILM

(57) Provided are: an organic thin film transistor element including an organic semiconductor layer that includes an organic semiconductor compound, in which a content of one kind or two or more kinds of atoms selected from the group consisting of Li, Na, P, K, Fe, Pd, Sn, B, Cl, Br, and I in the organic semiconductor layer is 300 to 700 ppm; an organic semiconductor film-forming composition used for forming the organic semiconductor layer of the element; a method of forming an organic semiconductor film using the composition; and an organic semiconductor film formed of the composition.

FIG. 1

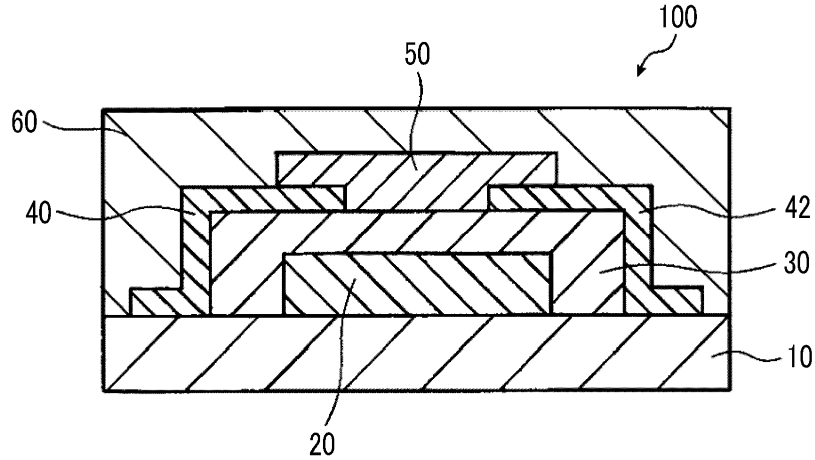


EP 3 442 043 A1

## Description

### BACKGROUND OF THE INVENTION

1. Field of the Invention

The present invention relates to an organic thin film transistor element, an organic semiconductor film-forming composition, a method of forming an organic semiconductor film, and an organic semiconductor film.

2. Description of the Related Art

In a display such as a liquid crystal display or an organic electroluminescence display or a logical circuit such as a radio frequency identifier (RFID (RF tag)) or a memory, a micro transistor such as a switching element is integrated. An organic thin film transistor (field effect transistor) in which a semiconductor layer is formed of an organic semiconductor compound can realize weight reduction, and a printing process can be applied to the manufacturing thereof. Therefore, this organic thin film transistor can realize cost reduction and has excellent flexibility. Thus, the organic thin film transistor has attracted attention as the next-generation transistor that is an alternative to a transistor including a silicon semiconductor layer, and development thereof has progressed.

In order to further improve performance of the organic thin film transistor, a chemical structure of the organic semiconductor compound forming the organic semiconductor layer has been investigated. In addition, it has been attempted to form the organic semiconductor layer using a high-purity organic semiconductor compound so as to improve the performance of the organic thin film transistor. In general, the organic semiconductor compound is synthesized by using a metal complex as a catalyst, and in the synthesized organic semiconductor compound, metal atoms derived from the catalyst, halogen atoms derived from raw materials, or the like typically remain as impurities. These impurities may cause excessive current leakage, a decrease in on/off ratio, or a decrease in carrier mobility.

JP2004-083650A describes an organic thin film transistor element including an organic semiconductor layer that is formed using an organic semiconductor compound from which impurities are removed using a supercritical solvent. In this organic thin film transistor element, current leakage is suppressed, and an on/off ratio is improved.

In addition, JP2003-347624A describes an organic thin film transistor element including an organic semiconductor layer that is formed using an organic semiconductor compound formed of a $\pi$-conjugated polymer in which the impurity content is 100 ppm or lower. JP2003-347624A describes that the current leakage of the organic thin film transistor element is effectively suppressed and an on/off ratio is significantly improved.

In addition, US2015/0218304A describes a method of reducing the palladium content in a synthesized diketo pyrrolo pyrrole (DPP) copolymer, and describes that a carrier mobility of an organic thin film transistor element is improved by forming an organic semiconductor layer of the organic thin film transistor element using the DPP copolymer in which the palladium content is reduced.

### SUMMARY OF THE INVENTION

In the manufacturing of an organic thin film transistor element, in general, an organic semiconductor layer is formed using a solution in which an organic semiconductor compound is dissolved in an organic solvent. More specifically, the organic semiconductor layer is formed by applying the solution to a substrate or a gate insulating layer and drying the applied solution. At this time, uniformity of the formed layer has a large effect on the performance of the element. That is, in a case where a manufacturing method in which there is a variation in a distribution of the organic semiconductor compound present in the organic semiconductor layer is adopted, there is a variation in performance such as carrier mobility between manufactured organic thin film transistor elements. In order to suppress the variation in performance and to improve manufacturing stability, it is important to form the layer using a solution in which the concentration of the organic semiconductor compound dissolved is increased to be high to some extent. To that end, it is necessary to improve solubility of the organic semiconductor compound in the organic solvent.

However, it cannot be said that organic semiconductor compounds of the related art including those described in JP2004-083650A, JP2003-347624A, and US2015/0218304A have sufficient solubility in a solvent. In a case where an organic semiconductor layer is formed using a solution in which the organic semiconductor compound is dissolved, it is difficult to sufficiently meet requirements for manufacturing stability.

An object of the present invention is to provide an organic thin film transistor element having excellent manufacturing stability (uniformity in performance between elements). In addition, another object of the present invention is to provide an organic semiconductor film-forming composition with which a variation in performance between obtained elements can be effectively suppressed for use in forming an organic semiconductor layer of an organic thin film transistor element, and a method of forming an organic semiconductor film using the composition. In addition, still another object

of the present invention is to provide an organic semiconductor film with which an organic thin film transistor element having excellent manufacturing stability can be provided.

As a result of thorough investigation for achieving the objects, the present inventors found that, by adding (causing to coexist) a specific amount of specific atoms to an organic semiconductor for forming an organic semiconductor layer, solubility of the organic semiconductor in a solvent can be improved, and also found that, by forming an organic semiconductor film using a solution in which the organic semiconductor is dissolved, a variation in carrier mobility between obtained organic thin film transistor elements can be effectively suppressed, and manufacturing stability of the elements can be improved.

The present invention has been completed based on the above findings as a result of repeated investigation.

The object of the present invention is achieved by the following means.

[1] An organic thin film transistor element comprising:

an organic semiconductor layer that includes an organic semiconductor compound,
in which a content of one kind or two or more kinds of atoms selected from the group consisting of Li, Na, P, K, Fe, Pd, Sn, B, Cl, Br, and I in the organic semiconductor layer is 300 to 700 ppm.

[2] The organic thin film transistor element according to [1],
in which the organic semiconductor compound is an organic semiconductor polymer including a structural unit represented by the following Formula (1),

$$\left( D\text{-}A \right) \qquad (1)$$

in Formula (1), D represents a group having an aromatic heterocycle having a monocyclic structure or a fused polycyclic structure which has at least one atom selected from the group consisting of a nitrogen atom, an oxygen atom, a sulfur atom, and a selenium atom as a ring-constituting atom, or a group having a fused polycyclic aromatic hydrocarbon ring, and
A represents a group having a structure represented by any one of the following Formulae (A-1) to (A-9),

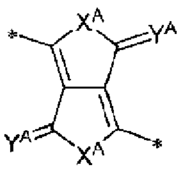

(A-1)

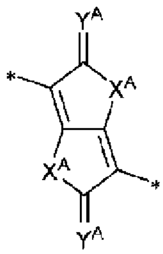

(A-2)

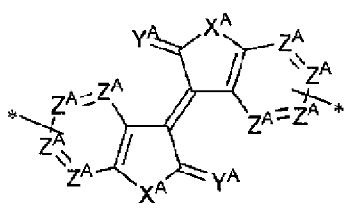

(A-3)

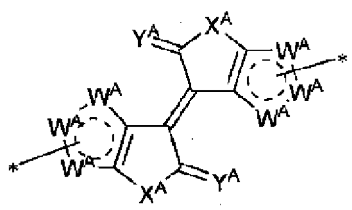

(A-4)

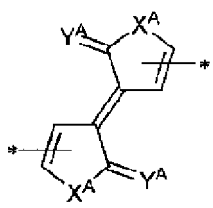

(A-5)

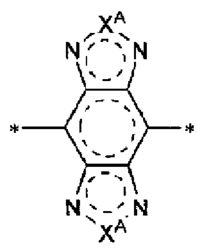

(A-6)

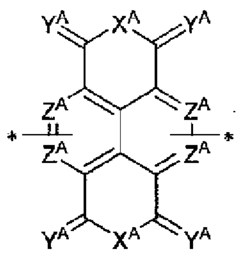

(A-7)

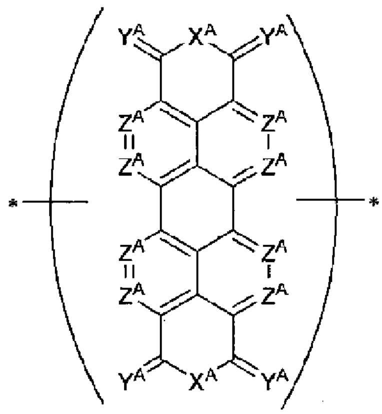

(A-8)

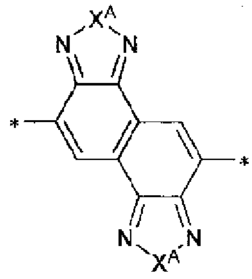

(A-9)

in Formulae (A-1) to (A-9),

$X^A$ represents an oxygen atom, a sulfur atom, a selenium atom, or $NR^X$,
$R^X$ represents an alkyl group or a group represented by the following Formula (1-1),
$Y^A$ represents an oxygen atom or a sulfur atom,
$Z^A$ represents $CR^{A2}$ or a nitrogen atom,
$W^A$ represents $C(R^{A2})_2$, $NR^{A1}$, a nitrogen atom, $CR^{A2}$, an oxygen atom, a sulfur atom, or a selenium atom,
$R^{A1}$ represents an alkyl group, a group represented by the following Formula (1-1), or a single bond,
$R^{A2}$ represents a hydrogen atom, a halogen atom, an alkyl group, or a single bond, and
* represents a binding site for incorporation into A in Formula (1), and

$$*\text{-}L_a\text{-}Ar\{L_b)_l \qquad (1\text{-}1)$$

in Formula (1-1),

$L_a$ represents an alkylene group having 1 to 20 carbon atoms,
Ar represents an aromatic heterocyclic group or an aromatic hydrocarbon group having 6 to 18 carbon atoms,
$L_b$ represents an alkyl group having 1 to 100 carbon atoms,
1 represents an integer of 1 to 5, and
* represents a binding site.

[3] The organic thin film transistor element according to [2],
in which D in Formula (1) represents a group represented by the following Formula (D-1),

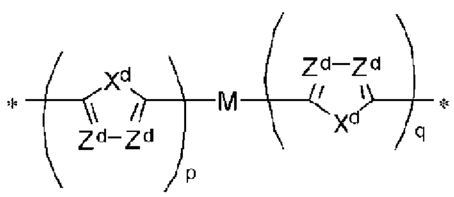

(D-1)

in Formula (D-1),

$X^d$ represents an oxygen atom, a sulfur atom, a selenium atom, or $NR^{D1}$,
$R^{D1}$ represents an organic group,
$Z^d$ represents a nitrogen atom or $CR^{D2}$,
$R^{D2}$ represents a hydrogen atom or an organic group,
M represents a single bond, an aromatic heterocyclic group, an aromatic hydrocarbon group, an alkenylene group, or an alkynylene group, or a divalent group including a combination of two or more selected from the group consisting of an aromatic heterocyclic group, an aromatic hydrocarbon group, an alkenylene group, and

an alkynylene group,
p and q represent an integer of 0 to 4, and
* represents a binding site for incorporation into a structural unit represented by Formula (1).

[4] The organic thin film transistor element according to [2] or [3],
in which the structural unit represented by Formula (1) is a structural unit represented by any one of the following Formulae (2) to (4),

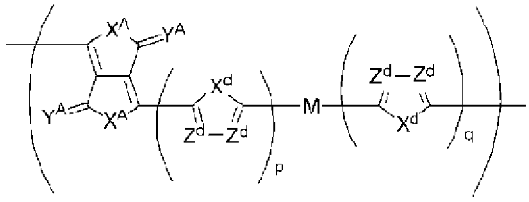
(2)

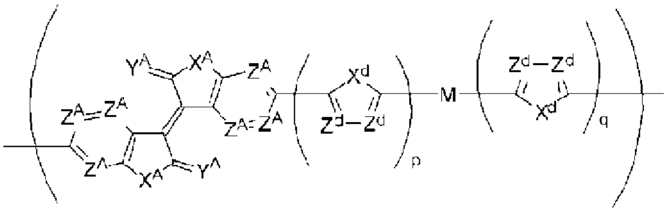
(3)

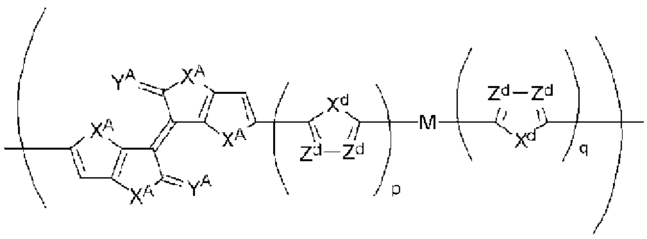
(4)

in Formulae (2) to (4),

$X^A$, $Y^A$, and $Z^A$ have the same definitions as $X^A$, $Y^A$, and $Z^A$ described regarding Formulae (A-1) to (A-9), respectively, and
$X^d$, $Z^d$, M, p, and q have the same definitions as $X^d$, $Z^d$, M, p, and q described regarding Formula (D-1), respectively.

[5] The organic thin film transistor element according to [2] or [3],
in which the structural unit represented by Formula (1) is a structural unit represented by the following Formula (5),

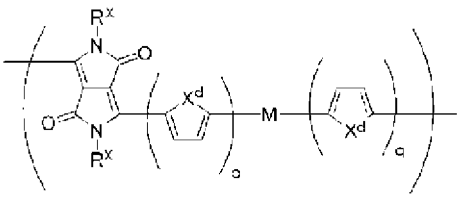
(5)

in Formula (5),

$R^X$ has the same definition as $R^X$ described regarding Formulae (A-1) to (A-9), and
$X^d$, M, p, and q have the same definitions as $X^d$, M, p, and q described regarding Formula (D-1), respectively.

[6] The organic thin film transistor element according to any one of [1] to [5],
in which a content of one kind or two or more kinds of atoms selected from the group consisting of Na, P, Fe, Pd,

Sn, B, Br, and I in the organic semiconductor layer is 300 to 700 ppm.
[7] An organic semiconductor film-forming composition comprising:

an organic semiconductor compound; and
one kind or two or more kinds of atoms selected from the group consisting of Li, Na, P, K, Fe, Pd, Sn, B, Cl, Br, and I, in which a proportion of a content of the one kind or two or more kinds of atoms selected from the group consisting of Li, Na, P, K, Fe, Pd, Sn, B, Cl, Br, and I with respect to the sum of a content of the organic semiconductor compound and the content of the one kind or two or more kinds of atoms selected from the group consisting of Li, Na, P, K, Fe, Pd, Sn, B, Cl, Br, and I is 300 to 700 ppm.

[8] The organic semiconductor film-forming composition according to [7],
in which the organic semiconductor compound is an organic semiconductor polymer including a structural unit represented by the following Formula (1),

$$-\!\left(\text{D-A}\right)\!- \qquad (1)$$

in Formula (1), D represents a group having an aromatic heterocycle having a monocyclic structure or a fused polycyclic structure which has at least one atom selected from the group consisting of a nitrogen atom, an oxygen atom, a sulfur atom, and a selenium atom as a ring-constituting atom, or a group having a fused polycyclic aromatic hydrocarbon ring, and
A represents a group having a structure represented by any one of the following Formulae (A-1) to (A-9),

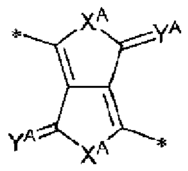

(A-1)

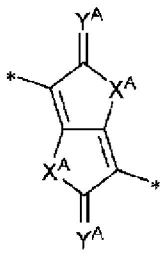

(A-2)

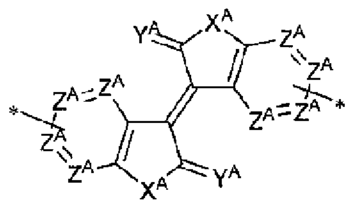

(A-3)

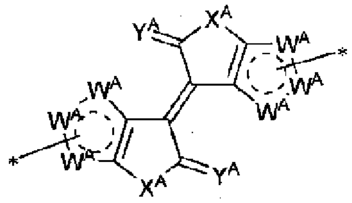

(A-4)

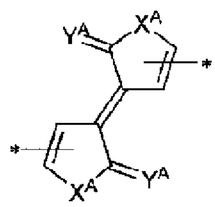

(A-5)

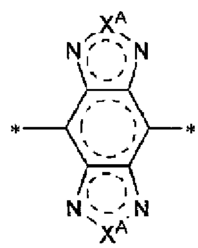

(A-6)

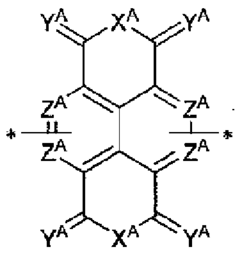

(A-7)

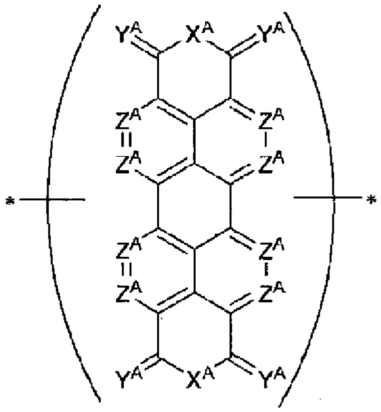

(A-8)

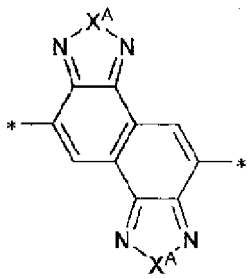

(A-9)

in Formulae (A-1) to (A-9),

$X^A$ represents an oxygen atom, a sulfur atom, a selenium atom, or $NR^X$,
$R^X$ represents an alkyl group or a group represented by the following Formula (1-1),
$Y^A$ represents an oxygen atom or a sulfur atom,
$Z^A$ represents $CR^{A2}$ or a nitrogen atom,
$W^A$ represents $C(R^{A2})_2$, $NR^{A1}$, a nitrogen atom, $CR^{A2}$, an oxygen atom, a sulfur atom, or a selenium atom,
$R^{A1}$ represents an alkyl group, a group represented by the following Formula (1-1), or a single bond,
$R^{A2}$ represents a hydrogen atom, a halogen atom, an alkyl group, or a single bond, and
* represents a binding site for incorporation into A in Formula (1), and

$$*\text{-}L_a\text{-}Ar\{L_b)_l \qquad (1\text{-}1)$$

in Formula (1-1),

$L_a$ represents an alkylene group having 1 to 20 carbon atoms,
Ar represents an aromatic heterocyclic group or an aromatic hydrocarbon group having 6 to 18 carbon atoms,
$L_b$ represents an alkyl group having 1 to 100 carbon atoms,
1 represents an integer of 1 to 5, and
* represents a binding site.

[9] The organic semiconductor film-forming composition according to [7] or [8], further comprising:
a solvent.
[10] A method of forming an organic semiconductor film comprising:
forming an organic semiconductor film using the organic semiconductor film-forming composition according to any one of [7] to [9].
[11] An organic semiconductor film comprising:

an organic semiconductor compound; and
at least one atom selected from the group consisting of Li, Na, P, K, Fe, Pd, Sn, B, Cl, Br, and I,
in which a content of the at least one atom selected from the group consisting of Li, Na, P, K, Fe, Pd, Sn, B, Cl, Br, and I in the organic semiconductor film is 300 to 700 ppm.

In this specification, numerical ranges represented by "to" include numerical values before and after "to" as lower limit values and upper limit values.
In this specification, "(meth)acrylate" represents either or both of acrylate and methacrylate. In addition, "(meth)acrylic acid" represents either or both of acrylic acid and methacrylic acid.
The meaning of compounds described in this specification include not only the compounds themselves but also salts and ions thereof. In addition, within a range where a desired effect does not deteriorate, a part of the structure may be changed.
In addition, in a case where it is not clearly described that a compound is substituted or unsubstituted, this

compound has any substituent within a range where a desired effect does not deteriorate. The same shall be applied to a substituent, a linking group, or the like (hereinafter, referred to as "substituent or the like").

In this specification, in a case where a plurality of substituents or the like represented by a specific reference numeral are present or a plurality of substituents or the like are simultaneously defined, the respective substituents or the like may be the same as or different from each other unless specified otherwise. The same shall be applied to definition of the number of substituents or the like. In addition, in a case where a plurality of substituents or the like are close to (in particular, adjacent to) each other, the substituents or the like may be linked to each other to form a ring unless specified otherwise.

In this specification, in a case where a plurality of structural units represented by the same chemical formula shown are present in a polymer, the respective structural units present in the polymer may be the same as or different from each other.

In addition, in a case where the number of carbon atoms in a group is limited, the number of carbon atoms in this group represents the total number of carbon atoms including substituents unless specified otherwise.

In the present invention, in a case where a group can form an acyclic skeleton and a cyclic skeleton, this group includes a group having an acyclic skeleton and a group having a cyclic skeleton unless specified otherwise. For example, an alkyl group includes a linear alkyl group, a branched alkyl group, and a cycloalkyl group. In a case where a group can form a cyclic skeleton, the lower limit of the number of atoms of the group forming a cyclic skeleton is not limited to the lower limit of the number of atoms specifically described regarding this group, and is 3 or more and preferably 5 or more.

In this specification, "ppm" represents "mass ppm".

In the organic thin film transistor element according to the present invention, a variation in performance between elements can be effectively suppressed, and manufacturing stability is excellent. In addition, in the organic semiconductor film-forming composition according to the present invention, solubility of the organic semiconductor compound in the composition is excellent. By forming the organic semiconductor layer of the organic thin film transistor element using this composition, a variation in performance between the obtained elements can be effectively suppressed. In the method of forming an organic semiconductor film according to the present invention, an organic semiconductor film having more uniform film characteristics can be obtained, and an organic thin film transistor element having excellent manufacturing stability can be provided. In addition, with the organic semiconductor film according to the present invention, an organic thin film transistor element having excellent manufacturing stability can be provided.

The above-described and other characteristics and advantageous effects of the present invention will be clarified from the following description appropriately with reference to the accompanying drawings.

## BRIEF DESCRIPTION OF THE DRAWINGS

Fig. 1 is a schematic cross-sectional view showing an aspect of a bottom gate-bottom contact type organic thin film transistor element as an example of the semiconductor element according to an embodiment of the present invention.

Fig. 2 is a schematic cross-sectional view showing an aspect of a bottom gate-top contact type organic thin film transistor element as an example of the semiconductor element according to the embodiment of the present invention.

## DESCRIPTION OF THE PREFERRED EMBODIMENTS

In an organic thin film transistor element according to an embodiment of the present invention, an organic semiconductor layer includes an organic semiconductor compound, and further include 300 to 700 ppm of one kind or two or more kinds of atoms selected from the group consisting of Li, Na, P, K, Fe, Pd, Sn, B, Cl, Br, and I in the organic semiconductor layer.

In this specification, "the one kind or two or more kinds of atoms selected from the group consisting of Li, Na, P, K, Fe, Pd, Sn, B, Cl, Br, and I" refers to not atoms constituting a molecular structure of the organic semiconductor compound but atoms separately present from the organic semiconductor compound in the organic semiconductor layer. In addition, these atoms are present in an ionized form or in the form of a complex or a compound. The content of the one kind or two or more kinds of atoms selected from the group consisting of Li, Na, P, K, Fe, Pd, Sn, B, Cl, Br, and I is measured using a method described below in Examples.

In the present invention, "the content of the one kind or two or more kinds of atoms selected from the group consisting of Li, Na, P, K, Fe, Pd, Sn, B, Cl, Br, and I is 300 to 700 ppm" represent that, in a case where the organic semiconductor layer includes one kind of atoms selected from the group consisting of Li, Na, P, K, Fe, Pd, Sn, B, Cl, Br, and I, the content of the one kind of atoms is 300 to 700 ppm, and represents that, in a case where the organic semiconductor layer includes one kind of atoms selected from the group consisting of Li, Na, P, K, Fe, Pd, Sn, B, Cl, Br, and I, the total content of the two or more kinds of atoms is 300 to 700 ppm. The same shall be applied to "the content

of one kind or two or more kinds of atoms selected from the group consisting of Na, P, Fe, Pd, Sn, B, Br, and I".

In this specification, "the one kind or two or more kinds of atoms selected from the group consisting of Li, Na, P, K, Fe, Pd, Sn, B, Cl, Br, and I" will also be referred to as "atoms AT".

From the viewpoint of further improving the effects of the present invention, it is preferable that the atoms AT are one kind or two or more kinds of atoms selected from the group consisting of Na, P, Fe, Pd, Sn, B, Br, and I.

A preferable embodiment of the organic thin film transistor element according to the present invention will be described below.

[Organic Thin Film Transistor Element]

An organic thin film transistor (also referred to as "organic TFT") element includes the above-described organic semiconductor layer according to the embodiment of the present invention, and may further include a source electrode, a gate insulating layer, a drain electrode, and a gate electrode.

The organic TFT element according to the embodiment of the present invention includes, on a substrate, a gate electrode, an organic semiconductor layer, a gate insulating layer that is provided between the gate electrode and the organic semiconductor layer, and a source electrode and a drain electrode that are provided adjacent to the organic semiconductor layer and are linked to each other through the organic semiconductor layer. In the organic TFT element, the organic semiconductor layer and the gate insulating layer are provided adjacent to each other.

A structure of the organic TFT element according to the embodiment of the present invention is not particularly limited as long as it includes the respective layers. For example, any structure such as a bottom contact type (a bottom gate-bottom contact type and a top gate-bottom contact type) or a top contact type (a bottom gate-top contact type and a top gate-top contact type) may be adopted. It is more preferable that the organic TFT element according to the embodiment of the present invention is a bottom gate-bottom contact type or bottom gate-top contact type (collectively referred to as "bottom gate type").

Hereinafter, an example of the organic TFT element according to the embodiment of the present invention will be described with reference to the accompanying drawings.

<Bottom Gate-Bottom Contact Type Organic Thin Film Transistor Element>

Fig. 1 is a schematic cross-sectional view showing a bottom gate-bottom contact type organic TFT element 100 as an example of the semiconductor element according to the embodiment of the present invention.

As shown in Fig. 1, the organic TFT element 100 includes a substrate (base material) 10, a gate electrode 20, a gate insulating film 30, a source electrode 40 and a drain electrode 42, an organic semiconductor film 50, and a sealing layer 60 in this order.

Hereinafter, the substrate (base material), the gate electrode, the gate insulating layer (film), the source electrode, the drain electrode, the organic semiconductor layer (film), and the sealing layer, and preparation methods thereof will be described in detail.

-Substrate-

The substrate functions to support the gate electrode, the source electrode, the drain electrode, and the like described below.

The kind of the substrate is not particularly limited, and examples thereof include a plastic substrate, a silicon substrate, a glass substrate, and a ceramic substrate. In particular, from the viewpoints of versatility, applicability to each device and costs, a silicon substrate, a glass substrate, or a plastic substrate is preferable.

The thickness of the substrate is not particularly limited and is, for example, preferably 10 mm or less, more preferably 2 mm or less, and still more preferably 1.5 mm or less. On the other hand, the thickness of the substrate is preferably 0.01 mm or more and more preferably 0.05 mm or more.

-Gate Electrode-

As the gate electrode, a typical electrode that is used as a gate electrode of an organic TFT element can be used without any particular limitation.

A material (electrode material) which forms the gate electrode is not particularly limited, and examples thereof include: a metal such as gold, silver, aluminum, copper, chromium, nickel, cobalt, titanium, platinum, magnesium, calcium, barium, or sodium; a conductive oxide such as $InO_2$, $SnO_2$, or indium tin oxide (ITO); a conductive polymer such as polyaniline, polypyrrole, polythiophene, polyacetylene, or polydiacetylene; a semiconductor such as silicon, germanium, or gallium-arsenic; and a carbon material such as fullerene, carbon nanotube, or graphite. Among these, the metal is

preferable, and silver or aluminum is more preferable.

The thickness of the gate electrode is not particularly limited and is preferably 20 to 200 nm.

The gate electrode may function as the substrate such as a silicon substrate. In this case, the substrate is not necessarily provided.

A method of forming the gate electrode is not particularly limited, and examples thereof include a method of performing vacuum deposition (hereinafter, simply referred to as "deposition") or sputtering on the substrate using the above-described electrode material and a method of applying or printing an electrode-forming composition including the above-described electrode material. In addition, in a case where an electrode is patterned, examples of a patterning method include a printing method such as ink jet printing, screen printing, offset printing, or relief printing (flexographic printing); a photolithography method, and a mask deposition method.

-Gate Insulating Layer-

The gate insulating layer is not particularly limited as long as it is an insulating film (layer) provided between the gate electrode and the organic semiconductor layer, and may have a single-layer structure or a multi-layer structure.

It is preferable that the gate insulating layer is formed of an insulating material, and preferable examples of the insulating material include an organic material such as an organic polymer and an inorganic material such as an inorganic oxide. From the viewpoint of handleability, in a case where a plastic substrate or a glass substrate is used, it is preferable that an organic material is used.

The organic polymer, the inorganic oxide, or the like is not particularly limited as long as it has insulating characteristics, and an organic polymer or an inorganic oxide with which a thin film, for example, a thin film having a thickness of 1 μm or less can be formed is preferable.

As the organic polymer or the inorganic oxide, one kind may be used alone, and two or more kinds may be used in combination. In addition, the gate insulating layer may be a hybrid layer formed of a mixture of the organic polymer and the inorganic oxide described below.

The organic polymer is not particularly limited, and examples thereof include: a polyalkyl (meth)acrylate such as polyvinyl phenol, polystyrene (PS), or polymethyl methacrylate; a cyclic fluoroalkyl polymer such as polyvinyl alcohol, polyvinyl chloride (PVC), polyvinylidene fluoride (PVDF), polytetrafluoroethylene (PTFE), or CYTOP (trade name, manufactured by AGC glass); a polyorganosiloxane such as polycycloolefin, polyester, polyethersulfone, polyether ketone, polyimide, poly(meth)acrylic acid, polybenzoxazole, an epoxy resin, or polydimethylsiloxane (PDMS); polysilsesquioxane; and butadiene rubber. In addition to the above-described examples, a thermosetting resin such as a phenolic resin, a novolac resin, a cinnamate resin, an acrylic resin, or a polyparaxylylene resin may also be used.

The organic polymer can also be used in combination with a compound having a reactive substituent such as an alkoxysilyl group, a vinyl group, an acryloyloxy group, an epoxy group, or a methylol group.

In a case where the gate insulating layer is formed of the organic polymer, it is preferable that the organic polymer is crosslinked and cured, for example, in order to improve solvent resistance, insulation resistance, and the like of the gate insulating layer. It is preferable that crosslinking is performed by generating an acid or a radical using either or both light and heat.

In a case where the organic polymer is crosslinked by a radical, as a radical generator that generates a radical using light or heat, for example, a thermal polymerization initiator (HI) and a photopolymerization initiator (H2) described in paragraphs [0182] to [0186] of JP2013-214649A, a photoradical generator described in paragraphs "0046" to "0051" of JP2011-186069A, or a photoradical polymerization initiator described in paragraphs "0042" to "0056" of JP2010-285518A can be preferably used, the contents of which are preferably incorporated herein by reference.

In addition, "a compound (G) having a number-average molecular weight (Mn) of 140 to 5000, having a crosslinking functional group, and not having a fluorine atom" which is described in paragraphs "0167" to "0177" of JP2013-214649A can also be preferably used, the contents of which are incorporated herein by reference.

In a case where the organic polymer is crosslinked by an acid, as a photoacid generator that generates an acid using light, for example, a photocationic polymerization initiator described in paragraphs "0033" and "0034" of JP2010-285518A or an acid generator, in particular, a sulfonium salt or an iodonium salt described in paragraphs "0120" to "0136" of JP2012-163946A can be preferably used, the contents of which are preferably incorporated herein by reference.

As a thermal acid generator (catalyst) that generates an acid using heat, for example, a thermal cationic polymerization initiator, in particular, an onium salt or the like described in paragraphs "0035" to "0038" of JP2010-285518A or a catalyst, in particular, a sulfonic acid or a sulfonic acid amine salt described in paragraphs "0034" and "0035" of JP2005-354012A can be preferably used, the contents of which are preferably incorporated herein by reference.

In addition, a crosslinking agent, in particular, a bifunctional or higher epoxy compound or oxetane compound described in paragraphs "0032" and "0033" of JP2005-354012A, a crosslinking agent, in particular, a compound having

two or more crosslinking groups at least one of which is a methylol group or an NH group described in paragraphs "0046" to "0062" of JP2006-303465A, or a compound having two or more hydroxymethyl groups or alkoxymethyl groups in a molecule described in paragraphs "0137" to "0145" of JP2012-163946A is also preferably used, the contents of which are preferably incorporated herein by reference.

Examples of forming the gate insulating layer using the organic polymer include a method of applying and curing the organic polymer. A coating method is not particularly limited, and examples thereof include the above-described printing methods. Among these, a wet coating method such as a microgravure coating method, a dip coating method, a screen coating printing method, a die coating method, or a spin coating method is preferable.

The inorganic oxide is not particularly limited, and examples thereof include: an oxide such as silicon oxide, silicon nitride ($SiN_Y$), hafnium oxide, titanium oxide, tantalum oxide, aluminum oxide, niobium oxide, zirconium oxide, copper oxide, or nickel oxide; a compound having a perovskite structure such as $SrTiO_3$, $CaTiO_3$, $BaTiO_3$, $MgTiO_3$, or $SrNb_2O_6$; and a composite oxide or a mixture thereof. Examples of the silicon oxide include silicon oxide ($SiO_X$), boron phosphorus silicon glass (BPSG), phosphorus silicon glass (PSG), borosilicate glass (BSG), arsenic silicate glass (AsSG), lead silicate glass (PbSG), silicon nitride oxide (SiON), spin-on-glass (SOG), and a low dielectric constant $SiO_2$ material (for example, polyarylether, a cycloperfluorocarbon polymer, benzocyclobutene, a cyclic fluororesin, polytetrafluoroethylene, fluorinated aryl ether, fluorinated polyimide, amorphous carbon, or organic SOG).

A method of forming the gate insulating layer using the inorganic oxide is not particularly limited. For example, a vacuum film formation method such as a vacuum deposition method, a sputtering method, or an ion plating or chemical vapor deposition (CVD) method can be used. In addition, the film formation may be assisted with plasma using predetermined gas, an ion gun, or a radical gun.

In addition, the gate insulating layer may also be formed by causing a precursor corresponding to each of metal oxides, specifically, a metal halide such as a chloride or a bromide, a metal alkoxide, a metal hydroxide, or the like is to react with an acid such as hydrochloric acid, sulfuric acid, or nitric acid or a base such as sodium hydroxide or potassium hydroxide in alcohol or water for hydrolysis. In a case where the solution-based process is used, the wet coating method can be used.

In addition to the above-described method, the gate insulating layer can also be formed optionally using a combination of any one of a lift-off method, a sol-gel method, an electrodeposition method, or a shadow mask method with a patterning method can also be optionally used.

It is preferable that a surface roughness of the gate insulating film is not high. It is preferable that an arithmetic average roughness Ra or a root-mean-square roughness $R_{MS}$ of the gate insulating layer surface is 0.5 nm or lower. In a case where a surface treatment is performed, a surface treatment that treats the insulating film surface not to be rough is preferable.

-Source Electrode and Drain Electrode-

In the organic TFT element according to the embodiment of the present invention, the source electrode is an electrode into which charges flow from the outside through a wiring. In addition, the drain electrode is an electrode from which charges flow to the outside through a wiring.

As a material which forms the source electrode and the drain electrode, the same electrode material as that of the gate electrode can be used. Among these, a metal is preferable, and gold or silver is more preferable. In addition, it is preferable that a charge injection layer is provided between the metal and the organic semiconductor so as to promote charge injection from the source into the organic semiconductor and to improve mobility.

The thickness of each of the source electrode and the drain electrode is not particularly limited and is preferably 1 nm or more and more preferably 10 nm or more. In addition, the thickness of each of the source electrode and the drain electrode is preferably 500 nm or less and more preferably 300 nm or less.

An interval (gate length) between the source electrode and the drain electrode can be appropriately determined and is, for example, preferably 200 μm or less and more preferably 100 μm or less. In addition, the gate width can be appropriately determined and is, for example, preferably 5000 μm or less and more preferably 1000 μm or less.

A method of forming the source electrode and the drain electrode is not particularly limited, and examples thereof include a method of performing vacuum deposition or sputtering using the electrode material on the substrate on which the gate electrode and the gate insulating film are formed and a method of applying or printing an electrode-forming composition to or on the substrate. In a case where the source electrode and the drain electrode are patterned, a patterning method thereof is the same as that of the gate electrode.

-Organic Semiconductor Layer-

In the organic TFT element according to the embodiment of the present invention, the organic semiconductor layer includes 300 to 700 ppm (preferably 320 to 650 ppm and more preferably 340 to 630 ppm) of the atoms AT as

described above. A method of forming the organic semiconductor layer is not particularly limited. For example, the organic semiconductor layer can be formed using a composition that includes the organic semiconductor compound and the atoms AT and in which a proportion of the content of the atoms AT with respect to the content of the organic semiconductor compound and the content of the atoms AT is 300 to 700 ppm (preferably 320 to 650 ppm and more preferably 340 to 630 ppm). More specifically, a composition is prepared by adding the atoms AT to the organic semiconductor compound constituting the organic semiconductor layer such that the concentration thereof is 300 to 700 ppm (preferably 320 to 650 ppm and more preferably 340 to 630 ppm). Alternatively, a composition (coating solution) is prepared by dissolving the organic semiconductor compound including the atoms AT in the organic solvent. This composition is applied (coated) to a layer (typically, the gate insulating layer) positioned below the organic semiconductor layer and is optionally dried. As a result, the organic semiconductor layer can be formed.

In addition, the coating solution may be prepared by dissolving the organic semiconductor compound and the atoms AT in the organic solvent such that the proportion of the atoms AT with respect to the sum of the content of the organic semiconductor compound and the content of the atoms AT is 300 to 700 ppm (preferably 320 to 650 ppm and more preferably 340 to 630 ppm).

The composition (coating solution) may include a binder resin and/or an insulating resin, and from the viewpoint of further improving the effects of the present invention, it is preferable that the composition (coating solution) does not include a polymer (for example, a binder resin or an insulating resin) other than the organic semiconductor compound.

In this specification, "the atoms AT are added to the organic semiconductor compound such that the concentration thereof is 300 to 700 ppm" or "the content of the atoms AT in the organic semiconductor compound is 300 to 700 ppm" represents that the proportion of the content of the atoms AT with respect to the sum of the content of the organic semiconductor compound and the content of atoms AT is 300 to 700 ppm.

As a supply source of the atoms AT used for adding the atoms AT, for example, a compound, a complex, or an ionic compound including the atoms AT can be widely used. By adding the compound, the complex, or the ionic compound to the composition (coating solution) used for forming the organic semiconductor layer, the atoms AT can be added to the organic semiconductor layer.

As a Li supply source, for example, metal lithium, lithium halide, or lithium carbonate can be used. In addition, as a Na supply source, for example, metal sodium, sodium halide, or sodium carbonate can be used. In addition, as a P supply source, for example, tri(o-tolyl)phosphine, triphenylphosphine, potassium phosphate, or 2-dicyclohexylphosphino-2',4',6'-triisopropylbiphenyl (Xphos) can be used. In addition, as a K supply source, for example, potassium halide, potassium carbonate, or potassium nitride can be used. In addition, as a Fe supply source, for example, iron oxide, iron hydroxide, or iron sulfate can be used. In addition, as a Pd supply source, for example, tris(dibenzylideneacetone)dipalladium, palladium acetate, or palladium chloride can be used. In addition, as an Sn supply source, for example, trimethyltin chloride, tributyltin chloride, or tributyltin oxide can be used. In addition, as a B supply source, for example, trimethyl borate, triisopropyl borate, or various boronic acid compounds can be used. In addition, as a Cl supply source, for example, a salt of chlorobenzene, chloroform, N-chlorosuccinimide, lithium chloride, or the like can be used. In addition, as a Br supply source, for example, bromine, N-bromosuccinimide, or a bromide can be used. In addition, as an I supply source, for example, iodine, iodobenzene, or an iodide can be used. The above-described configuration is merely an example of an aspect of the present invention. In the present invention, the supply sources of the atoms AT are not limited to the above-described examples.

The organic solvent used in the coating solution is not particularly limited. For example, a hydrocarbon compound such as hexane, octane, decane, toluene, xylene, mesitylene, ethylbenzene, amylbenzene, decaline, 1-methylnaphthalene, 1-ethylnaphthalene, 1,6-dimethylnaphthalene, or tetralin; a ketone compound such as acetone, methyl ethyl ketone, methyl isobutyl ketone, cyclohexanone, acetophenone, propiophenone, or butyrophenone; a halogenated hydrocarbon compound such as dichloromethane, chloroform, tetrachloromethane, dichloroethane, trichloroethane, tetrachloroethane, chlorobenzene, 1,2-dichlorobenzene, 1,2,4-trichlorobenzene, chlorotoluene, or 1-fluoronaphthalene; a heterocyclic compound such as pyridine, picoline, quinoline, thiophene, 3-butylthiophene, or thieno[2,3-b]thiophene; a halogenated heterocyclic compound such as 2-chlorothiophene, 3-chlorothiophene, 2,5-dichlorothiophene, 3,4-dichlorothiophene, 2-bromothiophene, 3-bromothiophene, 2,3-dibromothiophene, 2,4-dibromothiophene, 2,5-dibromothiophene, 3,4-dibromothiophene, or 3,4-dichloro-1,2,5-thiadiazole; an ester compound such as ethyl acetate, butyl acetate, amyl acetate, 2-ethylhexyl acetate, $\gamma$-butyrolactone, or phenyl acetate; an alcohol compound such as methanol, propanol, butanol, pentanol, hexanol, cyclohexanol, methyl cellosolve, ethyl cellosolve, or ethylene glycol; an ether compound such as dibutyl ether, tetrahydrofuran, dioxane, dimethoxyethane, anisole, ethoxybenzene, propoxybenzene, isopropoxybenzene, butoxybenzene, 2-methylanisole, 3-methylanisole, 4-methylanisole, 4-ethylanisole, dimethylanisole (any one of 2,3-, 2,4-, 2,5-, 2,6-, 3,4-, 3,5-, or 3,6-), or 1,4-benzodioxane; an amide compound or an imide compound such as N,N-dimethylformamide, N,N-dimethylacetamide, 1-methyl-2-pyrrolidone. 1-methyl-2-imidazolidinone, or 1,3-dimethyl-2-imidazolidinone; a sulfoxide compound such as dimethyl sulfoxide; a phosphate compound such as trimethyl phosphate; a nitrile compound such as acetonitrile or benzonitrile; a nitro compound such as nitromethane or nitrobenzene; and/or water can be used. As the solvent, one kind may be used alone, or a combination of plural kinds may be

used. It is preferable that an appropriate solvent is selected according to a printing method.

In particular, one kind or two or more kinds selected from the group consisting of the hydrocarbon compound, the halogenated hydrocarbon compound, the heterocyclic compound, the halogenated heterocyclic compound, and the ether compound are preferable.

In the coating solution, the content of the organic semiconductor compound (the content excluding Li, Na, P, K, Fe, Pd, Sn, B, Cl, Br, and I) is preferably 0.2 to 10 mass% and more preferably 0.3 to 5 mass%.

In addition, the content of the organic solvent in the coating solution is preferably 50 to 99.8 mass%, more preferably 70 to 99.7 mass%, still more preferably 80 to 99.5 mass%, even still more preferably 90 to 99.5 mass%, and even yet still more preferably 95 to 99.5 mass%.

A proportion of the organic semiconductor compound with respect to the balance of the coating solution excluding the organic solvent and the atoms AT is preferably 50 mass% or higher, more preferably 70 mass% or higher, still more preferably 80 mass% or higher, even still more preferably 90 mass% or higher, and may be 95 mass% or higher or 97 mass% or higher.

In the organic semiconductor layer of the organic TFT element according to the embodiment of the present invention the content of the organic semiconductor compound is preferably 50 mass% or higher, more preferably 70 mass% or higher, still more preferably 80 mass% or higher, even still more preferably 90 mass% or higher, and may be 95 mass% or higher or 97 mass% or higher.

It is preferable that the organic semiconductor layer does not include a polymer (for example, a binder resin or an insulating resin) other than the organic semiconductor compound.

The thickness of the organic semiconductor layer is appropriately adjusted according to the organic TFT element to be used, and cannot be uniquely determined and is, for example, preferably 10 to 500 nm and more preferably 20 to 200 nm.

As a coating method of the coating solution, a typical method can be used, and examples thereof include a bar coating method, a spin coating method, a knife coating method, a doctor blade method, an ink jet printing method, a flexographic printing method, a gravure printing method, and a screen printing method. Further, as the coating method of the coating solution, for example, a method (so-called gap casting method) of forming an organic semiconductor film described in JP2013-207085A or a method (so-called edge casting method or continuous edge casting method) of forming an organic semiconductor thin film described in WO2014/175351A can be preferably used.

For drying (drying treatment), appropriate conditions can be selected according to the kind of each of the components included in the organic semiconductor composition (composition for forming the organic semiconductor layer). Natural drying may be performed, but heating is preferable from the viewpoint of improving productivity. Heating conditions cannot be uniquely determined. For example, the heating temperature is preferably 30°C to 250°C, more preferably 40°C to 200°C, and still more preferably 50°C to 150°C, and the heating time is preferably 10 to 300 minutes and more preferably 20 to 180 minutes.

Next, a preferable aspect of the organic semiconductor compound used in the organic semiconductor layer will be described.

For the organic semiconductor layer according to the embodiment of the present invention, an organic semiconductor compound which can be used for forming the organic semiconductor layer of the organic TFT element can be used without any particular limitation. The organic semiconductor compound may be a low molecular weight compound or a polymer compound.

In a case where the organic semiconductor compound is a low molecular weight compound, a fused polycyclic aromatic compound can be preferably used. As the fused polycyclic aromatic compound, for example, a compound described in paragraphs "0055" to "0077" of JP5480510B can be used.

In addition, from the viewpoint of further improving the effects of the present invention, it is more preferable that a polymer including a structural unit represented by the following Formula (1) is used as the organic semiconductor compound.

$$-\!\!\left( D\text{-}A \right)\!\!- \qquad (1)$$

In Formula (1), D represents a group having an aromatic heterocycle having a monocyclic structure or a fused polycyclic structure which has at least one atom selected from the group consisting of N, O, S, and Se as a ring-constituting atom, or a group having a fused polycyclic aromatic hydrocarbon ring. It is preferable that D is a donating structural unit (electron donor unit) in consideration of a relationship with A. Conversely, it is preferable that A is an accepting structural unit (electron acceptor unit) in consideration of a relationship with D.

Hereinafter, the aromatic heterocycle having a monocyclic structure will also be referred to as "monocyclic aromatic heterocycle". In addition, the aromatic heterocycle having a fused polycyclic structure will also be referred to as "fused polycyclic aromatic heterocycle".

In a case where D represents a group having an aromatic heterocycle, it is preferable that this aromatic heterocycle has at least one S atom as a ring-constituting atom. In addition, in a case where D represents an aromatic heterocycle, it is preferable that D represents a group in which monocyclic aromatic heterocycles are linked through a single bond or a divalent linking group or a group in which a monocyclic aromatic heterocycle and a fused polycyclic aromatic heterocycle are linked through a single bond or a divalent linking group. The divalent linking group is preferably a conjugated chain and more preferably an ethenylene group, an arylene group, a heteroarylene group, or a combination of two or more kinds thereof. In a case where the divalent linking group is a combination of two or more kinds selected from the group consisting of an ethenylene group, an arylene group, and a heteroarylene group, a combination of an arylene group (preferably a phenylene group or a naphthylene group) and ethenylene is preferable. The number of aromatic heterocycles constituting D (in a case where D represents a fused polycyclic aromatic heterocycle, the number of aromatic heterocycles per one fused polycyclic aromatic heterocycle is one) is preferably 2 or more, more preferably 2 to 6, and still more preferably 2 to 4. In addition, in a case where the number of aromatic heterocycles constituting D is one, it is preferable that the aromatic heterocycle is a fused polycyclic aromatic heterocycle.

In a case where the aromatic heterocycle constituting D is a monocyclic aromatic heterocycle, the monocyclic aromatic heterocycle is preferably a 5-membered ring or a 6-membered ring, more preferably a 5-membered ring, still more preferably a thiophene ring or a furan ring, and even still more preferably a thiophene ring. In addition, in a case where the aromatic heterocycle constituting D is a fused polycyclic aromatic heterocycle, a monocyclic structure constituting the fused polycyclic aromatic heterocycle is preferably a 5-membered ring or a 6-membered ring and more preferably a 5-membered ring. In a case where the aromatic heterocycle constituting D is a fused polycyclic aromatic heterocycle, it is preferable that the fused polycyclic aromatic heterocycle is a bicyclic aromatic heterocycle.

An aspect where the aromatic heterocycle constituting D has a substituent may be adopted, and examples of the substituent (hereinafter, also referred to as "substituent $D^{S1}$") include an alkyl group, an alkenyl group, an alkynyl group, an aromatic hydrocarbon group, an aromatic heterocyclic group, a halogen atom, and a group represented by the following Formula (1-1).

The alkyl group which may be used as the substituent $D^{S1}$ may be linear, branched, or cyclic. The number of carbon atoms in the alkyl group is preferably 1 to 30 and more preferably 1 to 20. In the alkyl group, a group selected from the group consisting of -O-, -S-, and $-NR^{D3}-$ may be incorporated into a carbon chain of the alkyl group, or may be incorporated into a terminal on the binding site side of the alkyl group. $R^{D3}$ has the same definition and the same preferable aspect as $R^{1S}$ described below.

The alkenyl group or the alkynyl group which may be used as the substituent $D^{S1}$ may be linear or branched. The number of carbon atoms in the alkenyl group or the alkynyl group is preferably 2 to 30 and more preferably 2 to 20.

The number of carbon atoms in the aromatic hydrocarbon group which may be used as the substituent $D^{S1}$ is preferably 6 to 30.

The aromatic heterocyclic group which may be used as the substituent $D^{S1}$ is preferably a monocyclic aromatic heterocyclic group and more preferably a 5-membered to 7-membered monocyclic aromatic heterocyclic group. It is preferable that the aromatic heterocyclic group has a heteroatom selected from the group consisting of O, N, S, and Se as a ring-constituting heteroatom.

The halogen atom which may be used as the substituent $D^{S1}$ is F, Cl, Br, or I, more preferably F or Cl, and still more preferably F.

The group represented by Formula (1-1) which may be used as the substituent $D^{S1}$ is a group having the following structure.

$$*-L_a-Ar\!\left(L_b\right)_l \qquad (1-1)$$

In Formula (1-1), $L_a$ represents an alkylene group. This alkylene group may have at least one of -O-, -S-, or $-NR^{1S}-$ in a carbon chain.

In the present invention, examples of the alkylene group having -O- in a carbon chain include an aspect where -O- is introduced into the middle of a carbon-carbon bond of the alkylene group, an aspect where -O- is introduced into one terminal or both terminals of the alkylene group, and an aspect where -O- is introduced into the middle of a carbon-carbon bond of the alkylene group or into one terminal or both terminals of the alkylene group. The same shall be applied a case where the alkylene group has -S- or $-NR^{1S}-$. In addition, in a case where the alkylene group has -O-, -S-, and $-NR^{1S}-$, the total number of these groups is at least one, and the upper limit thereof is not particularly limited and is, for example, 5.

The alkylene group which may be used as $L_a$ may be linear, branched, or cyclic and is preferably a linear or branched alkylene group. From the viewpoint of carrier mobility, the number of carbon atoms in the alkylene group is preferably 1 to 20, more preferably 1 to 15, and still more preferably 1 to 10.

In a case where the alkylene group which may be used as $L_a$ is branched, the number of carbon atoms in the branch portion is included in the number of carbon atoms in the alkylene group represented by $L_a$. In a case where $L_a$ represents $-NR^{1S}-$ in which $R^{1S}$ has a carbon atom, the number of carbon atoms in $R^{1S}$ is not included in the number

of carbon atoms in the alkylene group which may be used as $L_a$.

Ar represents an aromatic heterocyclic group or an aromatic hydrocarbon group having 6 to 18 carbon atoms.

The aromatic heterocyclic group which may be used as Ar may be a monocyclic group or a fused ring group composed of 2 or more rings. From the viewpoints of carrier mobility, it is preferable that the aromatic hydrocarbon group is a monocyclic group. In a case where the aromatic heterocyclic group is a monocyclic group, it is preferable that the number of ring members is 5 to 7. In addition, as the ring-constituting heteroatom included in the aromatic heterocyclic group, a nitrogen atom, an oxygen atom, a sulfur atom, or a selenium atom is preferable, and a sulfur atom is more preferable.

The aromatic hydrocarbon group having 6 to 18 carbon atoms which may be used as Ar is not particularly limited, and examples thereof include a benzene ring group, a naphthalene ring group, and a group obtained by removing two or more hydrogen atoms from an aromatic hydrocarbon (for example, a fluorene ring) in which three or more rings are fused. Among these, from the viewpoint of further improving carrier mobility, a benzene ring group or a naphthalene ring group is preferable, and a benzene ring group is more preferable.

$L_b$ represents an alkyl group. This alkyl group may have at least one of -O-, -S-, or $-NR^{2S}-$ in a carbon chain.

In the present invention, examples of the alkyl group having -O- in a carbon chain include an aspect where -O- is introduced into the middle of a carbon-carbon bond of the alkyl group, an aspect where -O- is introduced into a terminal on the binding site side of the alkyl group, and an aspect where -O- is introduced into the middle of a carbon-carbon bond of the alkyl group or into a terminal on the binding site side of the alkyl group. The same shall be applied a case where the alkyl group has -S- or $-NR^{2S}-$. In addition, in a case where the alkyl group has -O-, -S-, and $-NR^{2S}-$, the total number of these groups is at least one, and the upper limit thereof is not particularly limited and is, for example, 5.

The alkyl group which may be used as $L_b$ may be linear, branched, or cyclic. From the viewpoint of carrier mobility, a linear or branched alkyl group is preferable, and a branched alkyl group is more preferable. In addition, the alkyl group may be an alkyl halide group having a halogen atom (preferably a fluorine atom, a chlorine atom, a bromine atom, or an iodine atom and more preferably a fluorine atom) as a substituent.

The number of carbon atoms in the alkyl group which may be used as $L_b$ is 1 to 100 and preferably 9 to 100.

In addition, in a case where the group represented by Formula (1-1) has a plurality of $L_b$'s, from the viewpoint of carrier mobility, at least one $L_b$ represents preferably the alkyl group having 9 to 100 carbon atoms, more preferably the alkyl group having 20 to 100 carbon atoms, and still more preferably the alkyl group having 20 to 40 carbon atoms.

In a case where the alkyl group which may be used as $L_b$ is branched, the number of carbon atoms in the branch portion is included in the number of carbon atoms in the alkyl group which may be used as $L_b$. In a case where $L_b$ includes $-NR^{2S}-$ in which $R^{2S}$ has a carbon atom, the number of carbon atoms in $R^{2S}$ is not included in the number of carbon atoms in the alkyl group which may be used as $L_b$.

$R^{1S}$ and $R^{2S}$ represent a hydrogen atom or a substituent. The substituent which may be used as $R^{1S}$ and $R^{2S}$ is not particularly limited, and examples thereof include an alkyl group (preferably a linear or branched alkyl group having 1 to 10 carbon atoms), a halogen atom (a fluorine atom, a chlorine atom, a bromine atom, or an iodine atom), and an aryl group (preferably an aromatic aryl group having 6 to 20 carbon atoms). In particular, $R^{1S}$ and $R^{2S}$ represent preferably a hydrogen atom or an alkyl group and more preferably an alkyl group.

The position of Ar (ring-constituting atom) to which $L_b$ is bonded is not particularly limited. For example, it is preferable that Ar is in the 2-position to 4-position with respect to $L_a$ (the ring-constituting atom to which $L_a$ is bonded is in the 1-position), and it is more preferable that at least one $L_b$ is bonded to the 4-position.

1 represents an integer of 1 to 5 and preferably 1 or 2. In a case where 1 represents an integer of 2 or more, a plurality of $L_b$'s may be the same as or different from each other.

In Formula (1-1), * represents a binding site.

In a case where D in Formula (1) represents a group having a fused polycyclic aromatic hydrocarbon ring, it is preferable that the number of carbon atoms in the fused polycyclic aromatic hydrocarbon ring is 10 to 20. Preferable examples of the fused polycyclic aromatic hydrocarbon ring include a fluorene ring, a naphthalene ring, and a tricyclic or tetracyclic fused polycyclic aromatic hydrocarbon ring. Among these, a fluorene ring, a naphthalene ring, an anthracene ring, a phenanthrene ring, a chrysene ring, or a pyrene ring is preferable.

In a case where D represents a group having a fused polycyclic aromatic hydrocarbon ring, the number of fused polycyclic aromatic hydrocarbon rings in D is preferably 1 to 6, more preferably 1 to 4, still more preferably 1 or 2, and even still more preferably 1.

It is still more preferable that D represents the group having a fused polycyclic aromatic hydrocarbon ring (that is, the fused polycyclic aromatic hydrocarbon group).

An aspect where the aromatic hydrocarbon group further has a substituent may be adopted, and examples of the substituent (hereinafter, also referred to as "substituent $D^{S2}$") include an alkyl group, a halogen atom, and a group represented by Formula (1-1). Preferable aspects of the alkyl group, the halogen atom, and the group represented by Formula (1-1) which may be used as the substituent $D^{S2}$ are the same as the preferable aspects of the alkyl group, the halogen atom, and the group represented by Formula (1-1) which may be used as the substituent $D^{S1}$, respectively.

It is more preferable that D in Formula (1) represents a group represented by the following Formula (D-1).

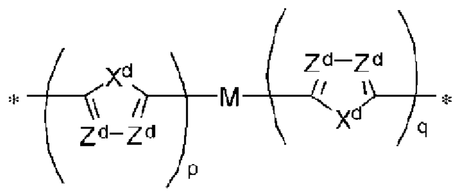

(D-1)

In Formula (D-1), * represents a binding site for incorporation into a structural unit represented by Formula (1). $X^d$ represents O, S, Se, or $NR^{D1}$, preferably O, S, or Se, and more preferably S.

$R^{D1}$ represents an organic group. $R^{D1}$ represents preferably an alkyl group (this alkyl group may have at least one of -O-, -S-, or $-NR^{D3}-$ ($R^{D3}$ has the same definition and the same preferable aspect as $R^{1S}$) in a carbon chain; the number of carbon atoms in the alkyl group is preferably 1 to 30 and more preferably 1 to 20), an alkynyl group (preferably having 2 to 30 carbon atoms), an alkenyl group (preferably having 2 to 30 carbon atoms), an aromatic hydrocarbon group (having preferably 6 to 30 carbon atoms), an aromatic heterocyclic group (preferably a 5-membered to 7-membered ring; as a ring-constituting heteroatom, O, N, S, or Se is preferable), a halogen atom (preferably F, Cl, Br, or I, more preferably F or Cl, and still more preferably F), or a group represented by Formula (1-1), more preferably an alkyl group, a halogen atom, or a group represented by Formula (1-1), and still more preferably a group represented by Formula (1-1).

$Z^d$ represents a nitrogen atom or $CR^{D2}$ and preferably $CR^{D2}$. $R^{D2}$ represents a hydrogen atom or an organic group. $R^{D2}$ represents preferably a hydrogen atom, an alkyl group (this alkyl group may have at least one of -O-, -S-, or $-NR^{D3}-$ ($R^{D3}$ has the same definition and the same preferable aspect as $R^{1S}$) in a carbon chain; the number of carbon atoms in the alkyl group is preferably 1 to 30 and more preferably 1 to 20), an alkynyl group (preferably having 2 to 30 carbon atoms), an alkenyl group (preferably having 2 to 30 carbon atoms), an aromatic hydrocarbon group (having preferably 6 to 30 carbon atoms), an aromatic heterocyclic group (preferably a 5-membered to 7-membered ring; as a ring-constituting heteroatom, O, N, S, or Se is preferable), a halogen atom (preferably F, Cl, Br, or I, more preferably F or Cl, and still more preferably F), or a group represented by Formula (1-1), more preferably a hydrogen atom, an alkyl group, a halogen atom, or a group represented by Formula (1-1), and still more preferably a group represented by Formula (1-1).

M represents a single bond, an aromatic heterocyclic group, an aromatic hydrocarbon group, an alkenylene group, an alkynylene group, or a divalent group including a combination thereof.

In Formula (D-1), the structural units in parentheses and M are rotatably bonded to each other at the bonding axis.

The aromatic heterocyclic group which may be used as M may be monocyclic or polycyclic. Examples of the aromatic heterocycle constituting the aromatic heterocyclic group include a group having a monocyclic aromatic heterocycle or a fused polycyclic aromatic heterocycle which may constitute D.

As the aromatic hydrocarbon group which may be used as M, an aromatic hydrocarbon group having 6 to 20 carbon atoms is preferable. As the aromatic hydrocarbon ring constituting the aromatic hydrocarbon group, a benzene ring, a biphenylene ring, a fluorene ring, a naphthalene ring, an aromatic hydrocarbon ring in which three rings or four rings are fused is more preferable, and a fluorene ring, a naphthalene ring, an anthracene ring, a phenanthrene ring, a chrysene ring, or a pyrene ring is still more preferable.

An aspect where the aromatic heterocyclic group or the aromatic hydrocarbon group which may be used as M further has a substituent may be adopted, and examples of the substituent include an alkyl group (this alkyl group may have at least one of -O-, -S-, or $-NR^{D3}-$ ($R^{D3}$ has the same definition and the same preferable aspect as $R^{1S}$) in a carbon chain), a halogen atom (preferably F, Cl, Br, or I, more preferably F or Cl, and still more preferably F), and a group represented by Formula (1-1).

As the alkenylene group which may be used as M, an alkenylene group having 2 to 10 carbon atoms is preferable, an alkenylene group having 2 to 4 carbon atoms is more preferable, and an ethenylene group is still more preferable.

As the alkynylene group which may be used as M, an alkynylene group having 2 to 10 carbon atoms is preferable, an alkynylene group having 2 to 4 carbon atoms is more preferable, and an ethynylene group is still more preferable.

p and q represent an integer of 0 to 4, preferably an integer of 1 to 3, and more preferably an integer of 1 or 2. It is preferable that p and q represent the same value. In addition, it is preferable that p+q is 2 to 4.

In a case where p+q is 0, it is preferable that M has a monocyclic or polycyclic aromatic heterocycle which has at least one heteroatom selected from the group consisting of N, O, S, and Se as a ring-constituting atom, or has a fused polycyclic aromatic hydrocarbon ring.

Examples of the structure of D constituting the structural unit of Formula (1) will be shown below, but the present invention is not limited to the following examples. In the following structural formula, a hydrogen atom may be substituted with an alkyl group (this alkyl group may have at least one of -O-, -S-, or $-NR^{D3}-$ in a carbon chain; $R^{D3}$ has the same

definition and the same preferable aspect as $R^{1S}$; the number of carbon atoms in the alkyl group is preferably 1 to 30 and more preferably 1 to 20), an alkenyl group, an alkynyl group, an aromatic hydrocarbon group, an aromatic heterocyclic group, a halogen atom, or a group represented by Formula (1-1). * represents a binding site for incorporation into the structural unit represented by Formula (1), and as $R^{D1}$, $R^{D1}$ described above is preferably used.

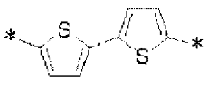 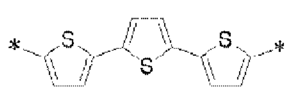 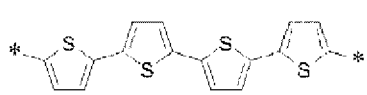

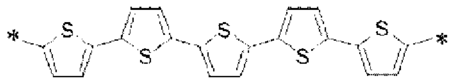 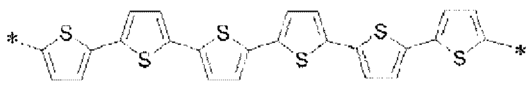

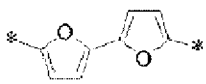 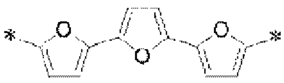 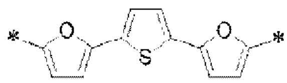 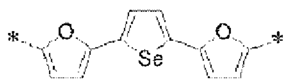

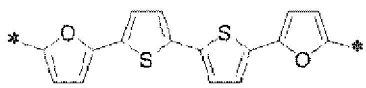 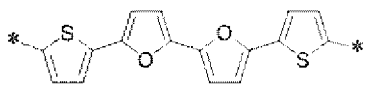

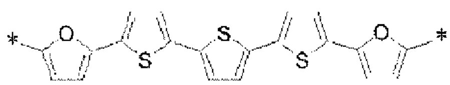 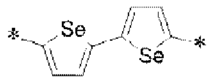 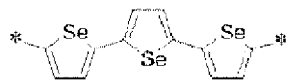

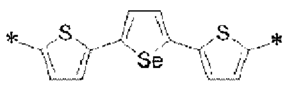 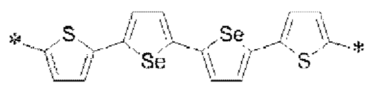 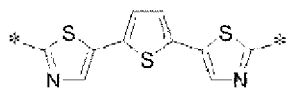

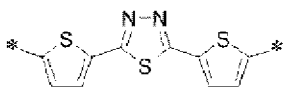 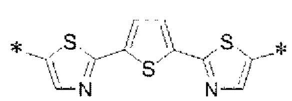 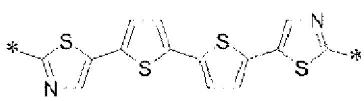

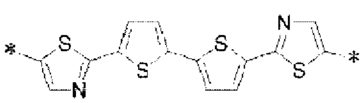 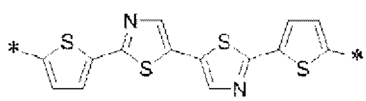 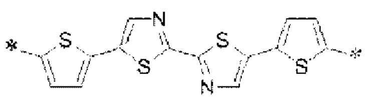

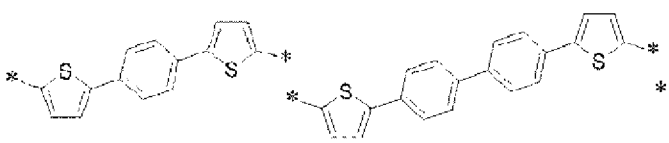 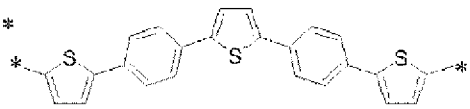

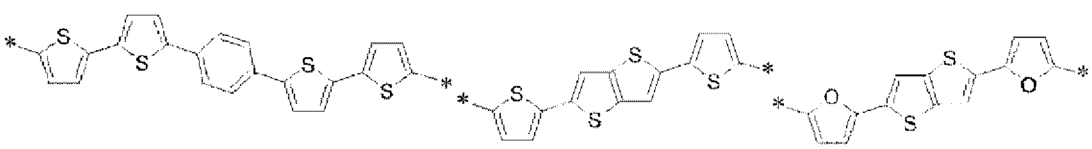

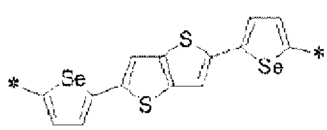 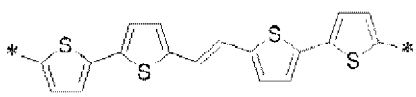

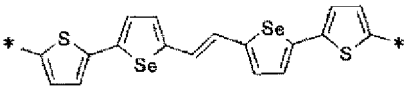 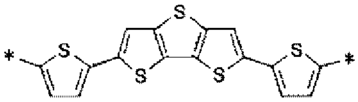

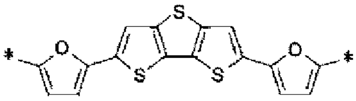 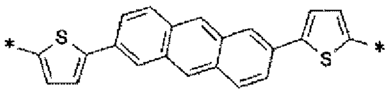

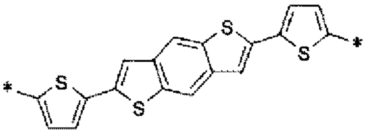 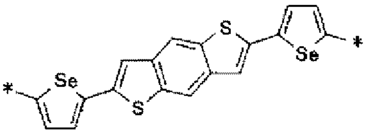 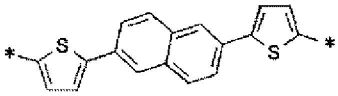

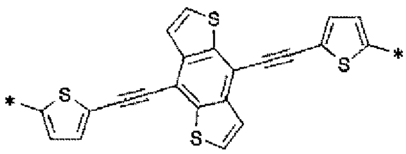 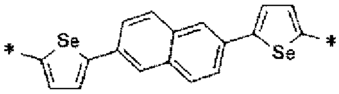

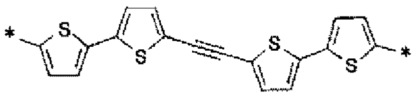 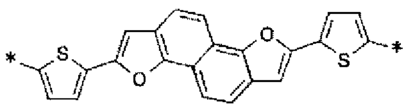

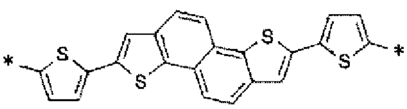 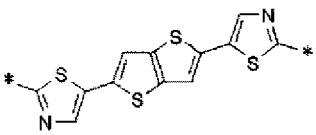

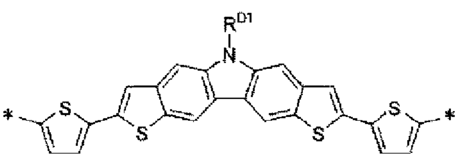 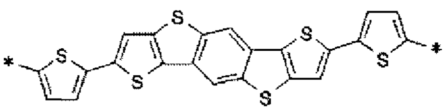

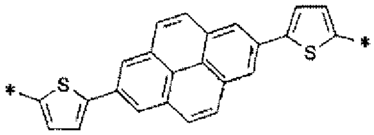 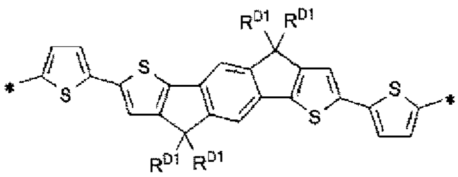

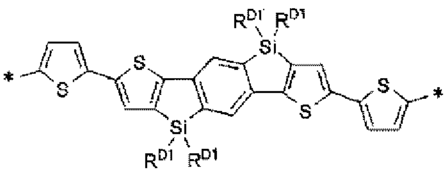 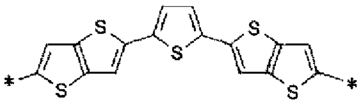

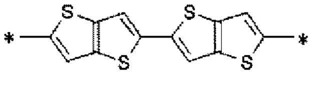 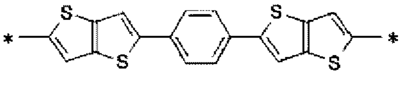

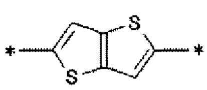 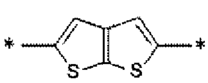 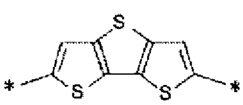 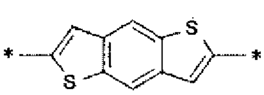

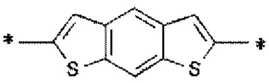
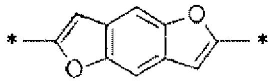
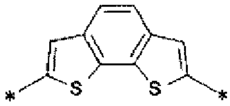
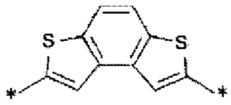

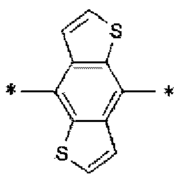
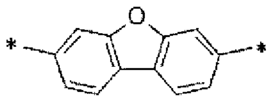
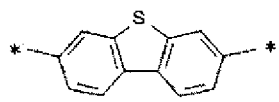

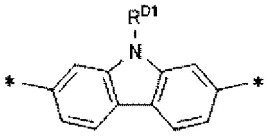
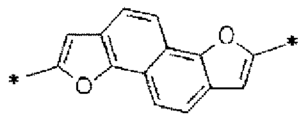
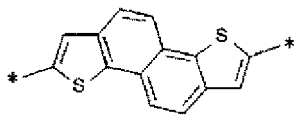

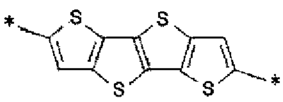
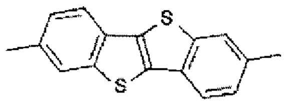
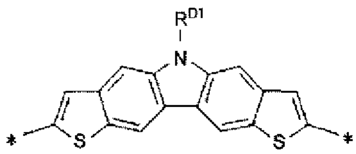

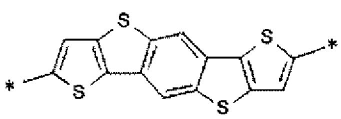
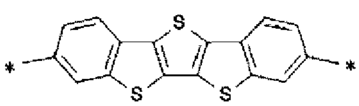
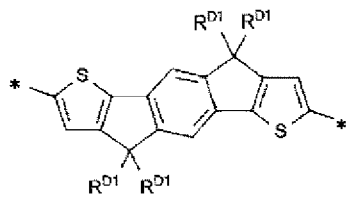

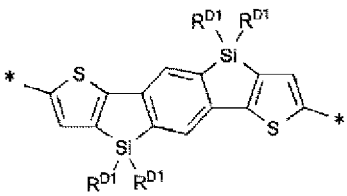
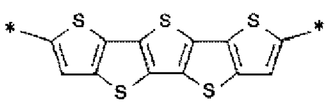
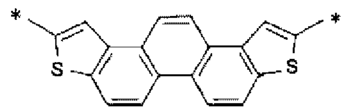

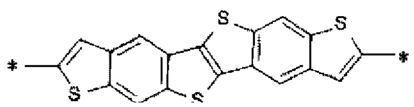
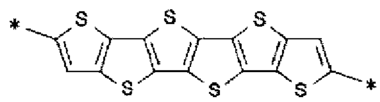

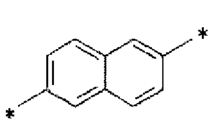
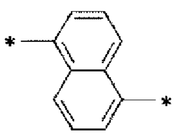
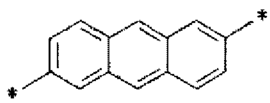
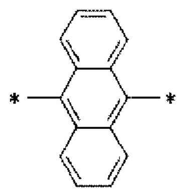

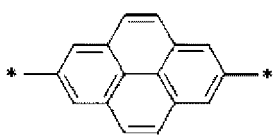
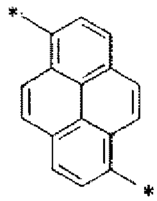

In Formula (1), A represents a group having an aromatic heterocyclic group represented by any one of the following Formulae (A-1) to (A-9), and preferably an aromatic heterocyclic group represented by any one of the following Formulae (A-1) to (A-9). In each of the following formulae, * represents a binding site to another group forming the

structural unit represented by Formula (1) (for example, a binding site for incorporation into A in Formula (1)).

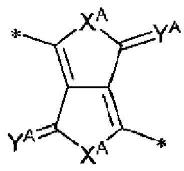

(A-1)

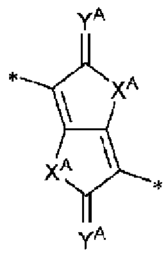

(A-2)

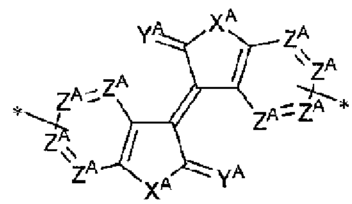

(A-3)

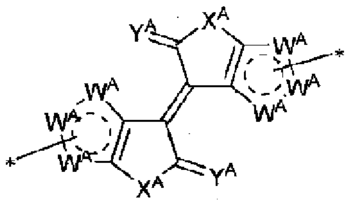

(A-4)

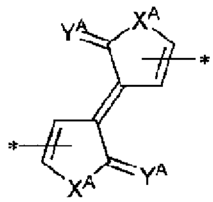

(A-5)

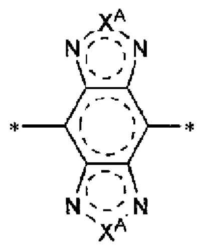

(A-6)

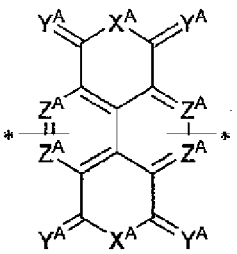

(A-7)

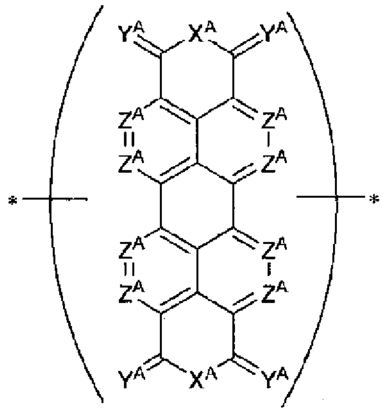

(A-8)

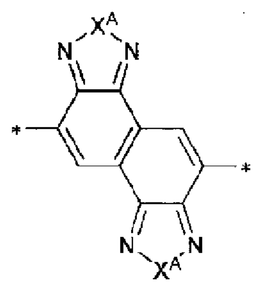

(A-9)

In Formula (A-4) and Formula (A-6), a round broken line in a 5-membered ring represents an aromatic ring in the 5-membered ring.

In Formulae (A-1) to (A-9), $X^A$ represents an oxygen atom, a sulfur atom, a selenium atom, or $NR^X$, and preferably a sulfur atom or $NR^X$.

$R^X$ represents an alkyl group or a group represented by Formula (1-1). The alkyl group which may be used as $R^X$ has the same definition and the same preferable ranges as the alkyl group which may be used as $R^{A1}$ described below.

$Y^A$ represents an oxygen atom or a sulfur atom and preferably an oxygen atom.

$Z^A$ represents $CR^{A2}$ or a nitrogen atom and preferably $CR^{A2}$.

$R^{A2}$ represents a hydrogen atom, a halogen atom, an alkyl group (this alkyl group may have at least one of -O-, -S-, or $-NR^{A3}-$ in a carbon chain), or a single bond. $R^{A2}$ representing a single bond represents that $R^{A2}$ represents a binding site to another structure.

It is preferable that $R^{A2}$ represents a hydrogen atom or a single bond.

In a case where $R^{A2}$ represents a halogen atom, as the halogen atom, a fluorine atom, a chlorine atom, a chlorine atom, a bromine atom, or an iodine atom can be used, and a fluorine atom is preferable. In a case where $R^{A2}$ represents the alkyl group, as the alkyl group, an alkyl group having 2 to 35 carbon atoms is preferable, and an alkyl group having 8 to 25 carbon atoms is more preferable. In addition, the alkyl group may be linear or branched. $R^{A3}$ represents a hydrogen atom or a substituent. The substituent which may be used as $R^{A3}$ is not particularly limited and has the same definition and the same preferable ranges as the substituent of $R^{1S}$ and $R^{2S}$.

In a case where $R^{A2}$ in $CR^{A2}$ represents a single bond, a C atom in $CR^{A2}$ is a binding site (in each of the formulae, represented by *) in each of Formulae (A-3), (A-7), and (A-8).

Specifically, in each of ring structures including $Z^A$ in Formula (A-3) and Formula (A-7), one $Z^A$ represents $CR^{A2}$, in which $R^{A2}$ represents a single bond. $CR^{A2}$ (carbon atom) including a single bond represents a binding site represented by * in each of the formulae. In addition, in Formula (A-8), two of eight $Z^A$'s represent $CR^{A2}$, in which $R^{A2}$ represents a single bond. The two $CR^{A2}$'s (carbon atom) including a single bond represent a binding site represented by * in Formula (A-8).

$W^A$'s each independently represent $C(R^{A2})_2$, $NR^{A1}$, a nitrogen atom, $CR^{A2}$, an oxygen atom, a sulfur atom, or a selenium atom, preferably $C(R^{A2})_2$, $CR^{A2}$, or a sulfur atom, and more preferably $CR^{A2}$ or a sulfur atom.

$R^{A1}$ represents an alkyl group (this alkyl group may have at least one of -O-, -S-, or $-NR^{A3}-$ in a carbon chain), a group represented by Formula (1-1), or a single bond. As $R^{A1}$, an alkyl group or a group represented by Formula (1-1) is preferable.

The alkyl group which may be used as $R^{A1}$ may be linear or branched. The number of carbon atoms in the alkyl group is preferably 2 to 35 and more preferably 8 to 25.

$R^{A2}$ and $R^{A3}$ in $W^A$ have the same definitions and the same preferable ranges as $R^{A2}$ and $R^{A3}$ in $Z^A$, respectively.

In each of two ring structures including $W^A$ in Formula (A-4), one $W^A$ adopts any one of the following aspects 1 to 3 and preferably the aspect 1.

Aspect 1: $W^A$ represents $CR^{A2}$, in which $R^{A2}$ represents a single bond
Aspect 2: $W^A$ represents $NR^{A1}$, in which $R^{A1}$ represents a single bond
Aspect 3: $W^A$ represents $C(R^{A2})_2$, in which one $R^{A2}$ represents a single bond and the other $R^{A2}$ represents a hydrogen atom, a halogen atom, or the alkyl group

In each of the aspects, $CR^{A2}$ (carbon atom), $NR^{A1}$ (nitrogen atom), or $C(R^{A2})_2$ (carbon atom) including a single bond represents a binding site (in the formula, represented by *) in Formula (A-4).

A represents preferably an aromatic heterocyclic group represented by any one of Formulae (A-1) to (A-4), (A-6), (A-7), and (A-9) among the Formulae (A-1) to (A-9), more preferably an aromatic heterocyclic group represented by Formula (A-1), Formula (A-2), or Formula (A-4), and still more preferably an aromatic heterocyclic group represented by Formula (A-1).

Examples of the aromatic heterocyclic groups represented by Formulae (A-1) to (A-9) will be shown below, but the present invention is not limited to these examples. In the following aromatic heterocyclic groups, $R^X$ and * are as described above.

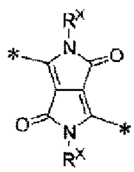
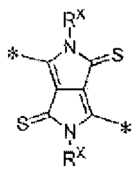
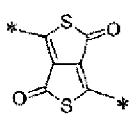
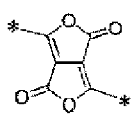
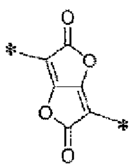
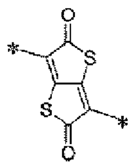
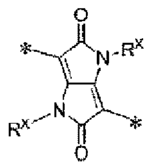

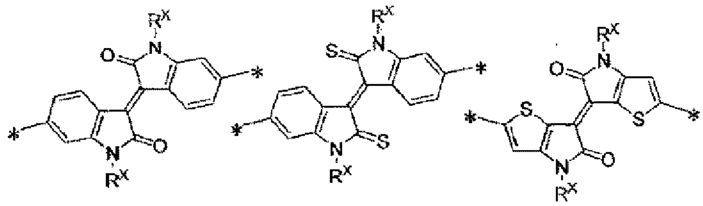
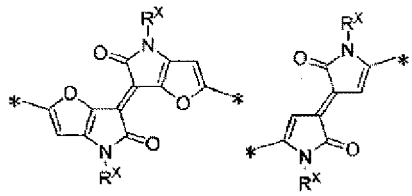

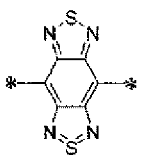
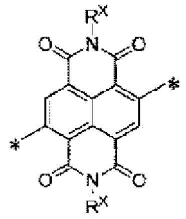
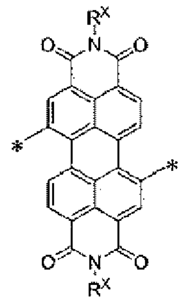
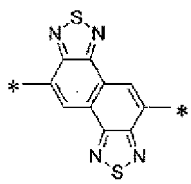

It is preferable that the structural unit represented by Formula (1) is a structural unit represented by any one of the following Formulae (2) to (4).

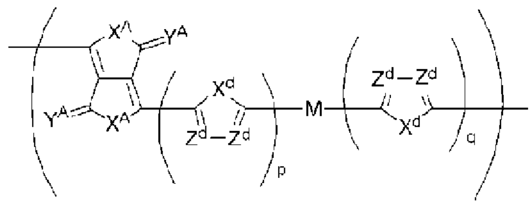
(2)

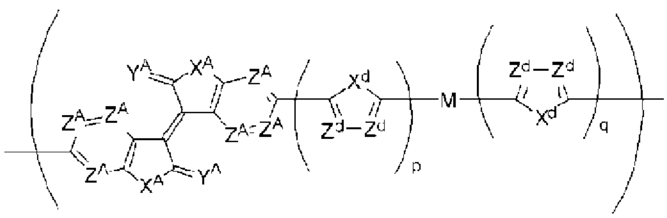
(3)

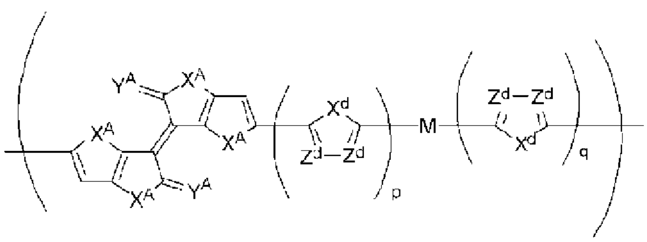
(4)

In Formulae (2) to (4),
$X^A$, $Y^A$, and $Z^A$ have the same definitions as $X^A$, $Y^A$, and $Z^A$ described regarding Formulae (A-1) to (A-9), respectively, and $X^d$, $Z^d$, M, p, and q have the same definitions as $X^d$, $Z^d$, M, p, and q described regarding Formula (D-1), respectively.
It is preferable that the structural unit represented by Formula (1) is a structural unit represented by the following Formula (5).

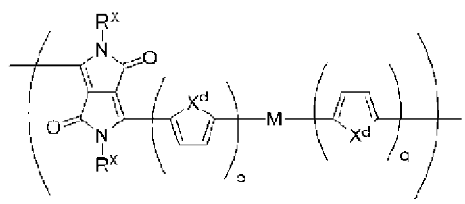
(5)

$R^X$ has the same definition and the same preferable aspect as $R^X$ described regarding Formulae (A-1) to (A-9).
$X^d$, M, p, and q have the same definitions as $X^d$, M, p, and q described regarding Formula (D-1), respectively.
Specific examples of the structural unit represented by Formula (1) will be shown below and in Examples, but the present invention is not limited thereto.
In the following exemplary compounds, m:n represents a molar ratio between repeating units.

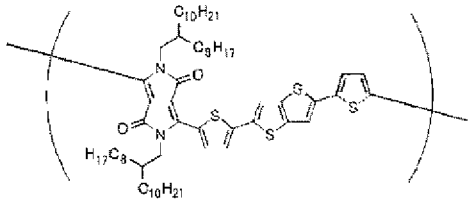

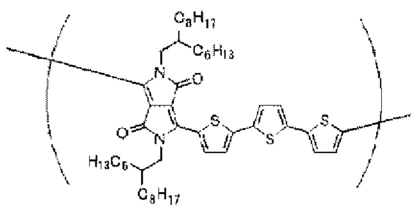

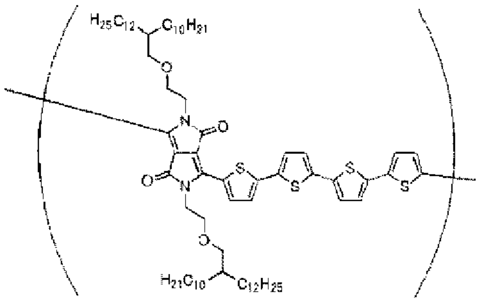

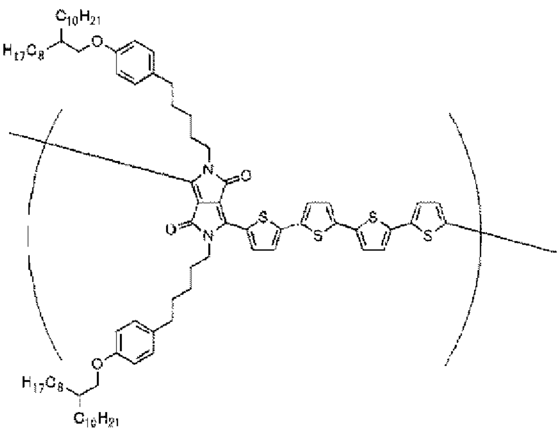

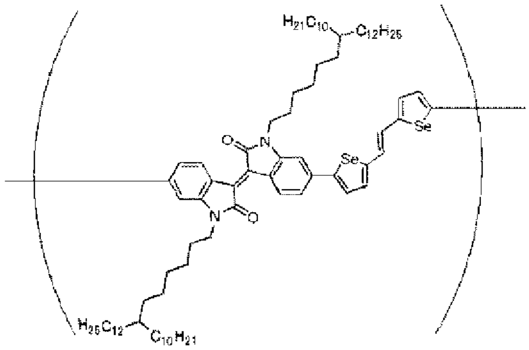

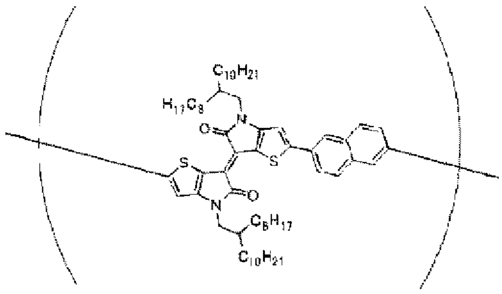

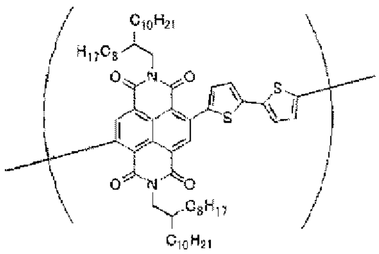

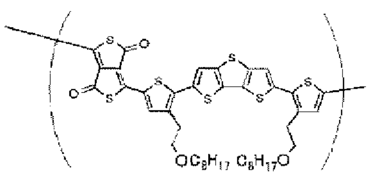

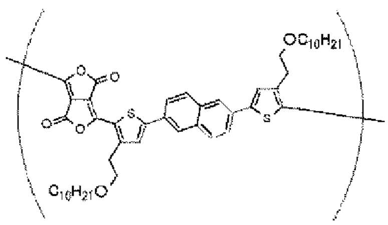

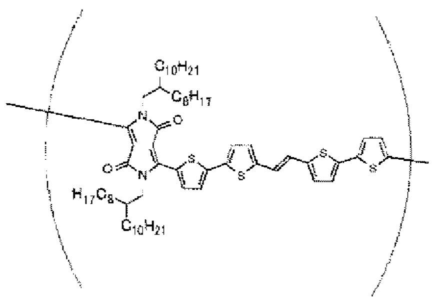

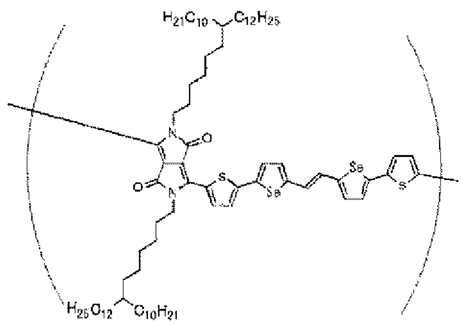

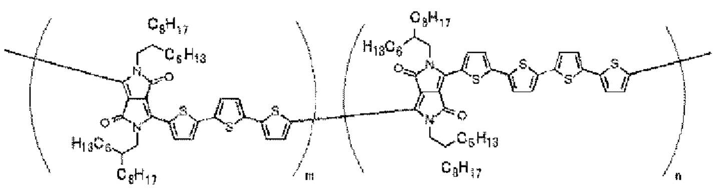

m : n=0.2 : 0.8
random copolymer

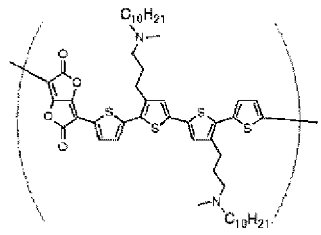

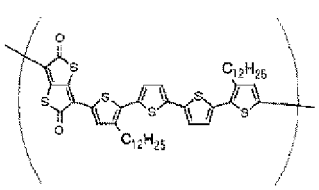

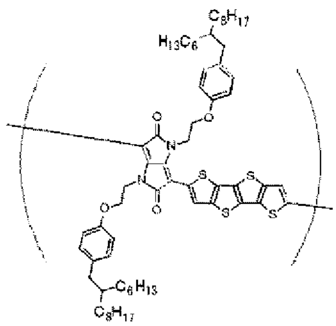

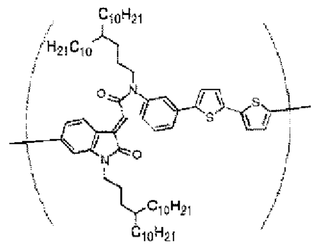

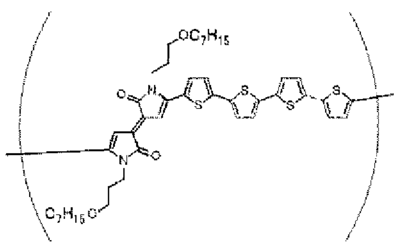

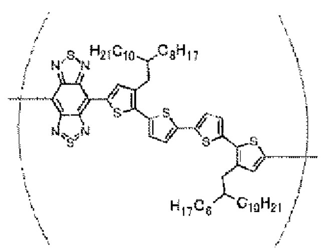

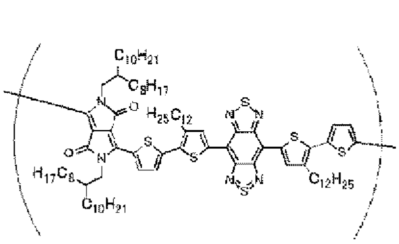

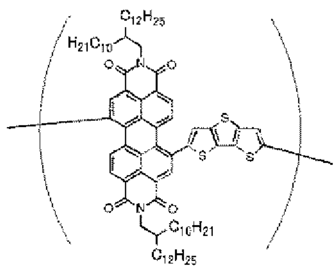

An organic semiconductor polymer including the structural unit represented by Formula (1) may include one structural unit represented by Formula (1) or two or more structural units represented by Formula (1).

The organic semiconductor polymer including the structural unit represented by Formula (1) includes two or more repeating units represented by Formula (1). The organic semiconductor polymer including the structural unit

represented by Formula (1) may be a random copolymer or a block copolymer. The organic semiconductor polymer including the structural unit represented by Formula (1) may be an oligomer in which the number of repeating units (polymerization degree) n is 2 to 9, or a polymer compound in which the number of repeating units (polymerization degree) n is 10 or more. Among these, it is preferable that the organic semiconductor polymer is a polymer compound from the viewpoints of carrier mobility and physical properties of the obtained organic semiconductor layer.

The polymerization degree n can be calculated based on a weight-average molecular weight described below and the mass of each of the repeating units.

The organic semiconductor polymer including the structural unit represented by Formula (1) may include a structural unit other than the structural unit represented by Formula (1).

In the organic semiconductor polymer including the structural unit represented by Formula (1), the content of the structural unit represented by Formula (1) is preferably 60 mass% or higher, more preferably 80 mass% or higher, and still more preferably 90 mass% or higher. It is preferable that the organic semiconductor polymer including the structural unit represented by Formula (1) is a polymer including the structural unit represented by Formula (1).

From the viewpoint of carrier mobility, the weight-average molecular weight of the organic semiconductor polymer including the structural unit represented by Formula (1) is preferably 2000 or higher, more preferably 10000 or higher, still more preferably 20000 or higher, even still more preferably 30000 or higher, and most preferably 45000 or higher. In addition, from the viewpoints of solubility, the weight-average molecular weight is preferably 1000000 or lower, more preferably 300000 or lower, still more preferably 200000 or lower, and even still more preferably 150000 or lower.

In the present invention, the weight-average molecular weight and the number-average molecular weight are measured by gel permeation chromatography (GPC) in terms of standard polystyrene. Specifically, for example, HLC-8121GPC (manufactured by Tosoh Corporation) is used as a GPC, two columns $GMH_{HR}$-H (20) HT (manufactured by Tosoh Corporation, 7.8 mm ID×30 cm) are used as columns, and 1,2,4-trichlorobenzene is used as an eluent. In addition, the measurement can be used using an infrared (IR) detector under conditions of sample concentration: 0.02 mass%, flow rate: 1.0 mL/min, sample injection volume: 300 μL, and measurement temperature: 160°C. In addition, a calibration curve can be obtained from 12 samples of "Standard samples, TSK standard, polystyrene": "F-128", "F-80", "F-40", "F-20", "F-10", "F-4", "F-2", "F-1", "A-5000", "A-2500", "A-1000", and "A-500" (manufactured by Tosoh Corporation).

A terminal structure of the organic semiconductor polymer including the structural unit represented by Formula (1) is not particularly limited and is not uniquely determined depending on whether or not the other repeating unit is present, the kind of a base material used for the synthesis, or the kind of a quenching agent (reaction terminator) used for the synthesis. Examples of the terminal structure include a hydrogen atom, a hydroxy group, a halogen atom, an ethylenically unsaturated group, an alkyl group, an aromatic heterocyclic group (preferably a thiophene ring), and an aromatic hydrocarbon group (preferably a benzene ring).

A synthesis method of the organic semiconductor polymer including the structural unit represented by Formula (1) is not particularly limited, and the organic semiconductor polymer including the structural unit represented by Formula (1) can be synthesized using a typical method. For example, respective precursor compounds with which the respective structural units constituting the polymer can be introduced are synthesized, and the respective precursors are caused to undergo a cross-coupling reaction such as a Suzuki coupling reaction or a Stille coupling reaction. As a result, the organic semiconductor polymer can be synthesized. The synthesis of the organic semiconductor polymer having a component (a) can be referred to, for example, JP2010-527327A, JP2007-516315A, JP2014-515043A, JP2014-507488A, JP2011-501451A, JP2010-018790A, WO2012/174561A, JP2011-514399A, and JP2011-514913A.

(Sealing Layer)

In the organic TFT element according to the embodiment of the present invention, it is preferable that the sealing layer is provided on the outermost layer from the viewpoint of durability. For the sealing layer, a sealing agent (sealing layer-forming composition) that is typically used in the organic TFT element can be used.

The thickness of the sealing layer is not particularly limited and is preferably 0.2 to 10 μm.

(Bottom Gate-Top Contact type Organic Thin Film Transistor Element)

Fig. 2 is a schematic cross-sectional view showing a bottom gate-top contact type organic TFT element 200 as an example of the semiconductor element according to the embodiment of the present invention.

As shown in Fig. 2, the organic TFT element 200 includes the substrate 10, the gate electrode 20, the gate insulating layer (film) 30, the organic semiconductor layer (film) 50, the source electrode 40 and the drain electrode 42, and the sealing layer 60 in this order.

The organic TFT element 200 is the same as the organic TFT element 100 except for the layer configuration (stack aspect). Accordingly, the details of the substrate, the gate electrode, the gate insulating layer, the source electrode, the drain electrode, the organic semiconductor layer, and the sealing layer are the same as those of the bottom gate-bottom contact type organic TFT element, and thus the description thereof will not be repeated.

The configuration of the gate electrode, the gate insulating layer, the organic semiconductor layer, the source electrode, the drain electrode, the sealing layer, and the like is applicable to not only the bottom gate type organic TFT element but also a top gate type organic TFT element.

Examples

The present invention will be described in more detail using Examples, but the present invention is not limited to the following Examples.

[Measurement Method of Atoms AT]

The content of the atoms AT in an organic semiconductor compound (a polymer or a low molecular weight compound) was determined using the following method.

The organic semiconductor compound and nitric acid were added to a Teflon (registered trade name) container and were heated in a microwave oven to be ashed, and then were dissolved in nitric acid. By using this solution as a sample, the content of the atoms AT was determined using ICP-MS HP 7700 (manufactured by Agilent Technologies Inc.).

[Synthesis Examples]

The following organic semiconductor compounds (polymers 1 to 13 and low molecular weight compounds 14 and 15 including the following constitutional units) were synthesized.

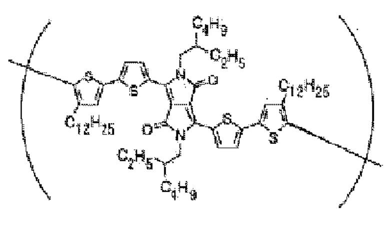

Polymer 1

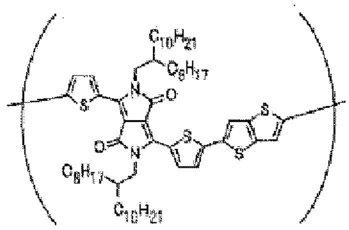

Polymer 2

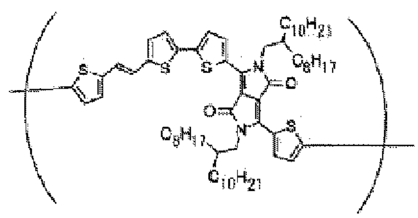

Polymer 3

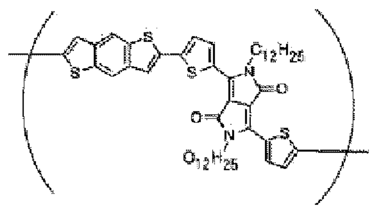

Polymer 4

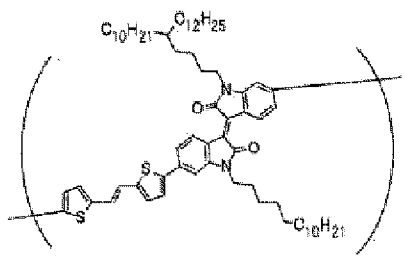

Polymer 5

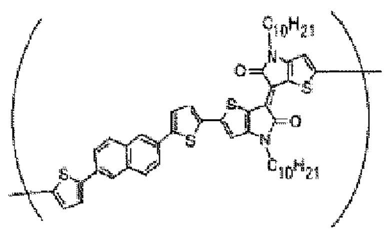

Polymer 6

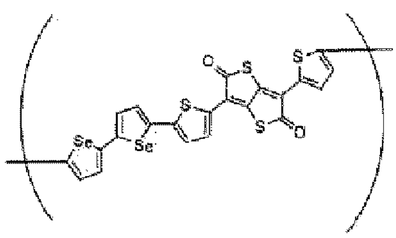

Polymer 7

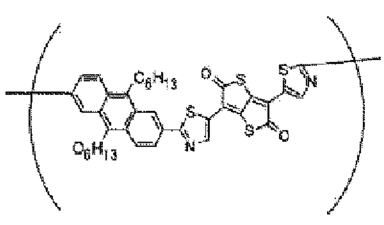

Polymer 8

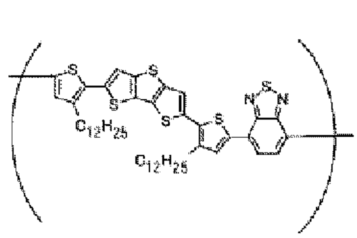

Polymer 9

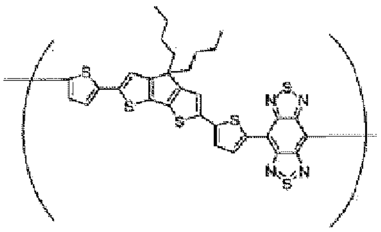

Polymer 10

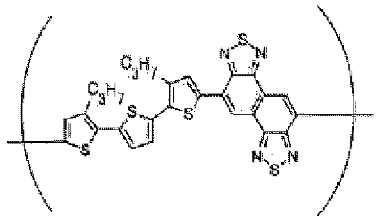

Polymer 11

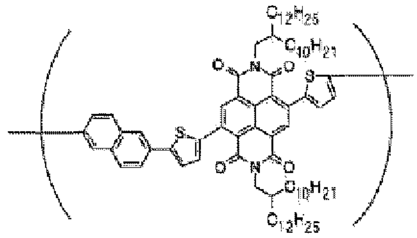

Polymer 12

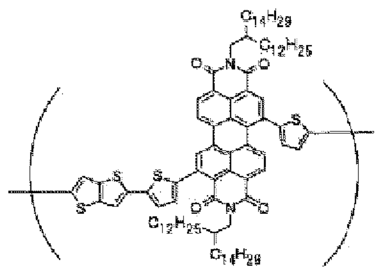

Polymer 13

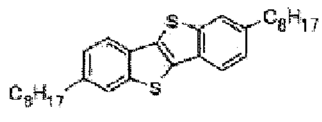

Low Molecular Weight Compound 14

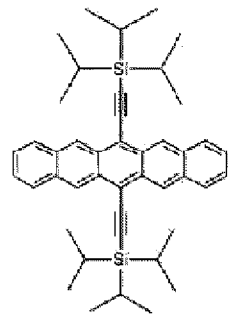

Low Molecular Weight Compound 15

<Synthesis Example 1: Synthesis of Polymer 1>

A polymer 1 was synthesized using the following scheme. In the following scheme, DMF represents N,N-dimethylformamide, NBS represents N-bromosuccinimide, and dba represents dibenzylideneacetone.

Scheme 1

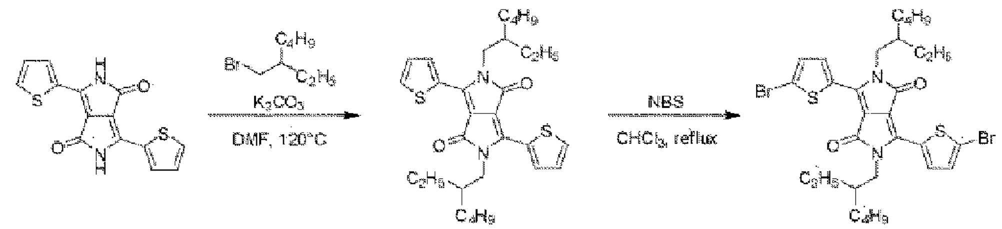


Intermediate 1

Intermediate 2

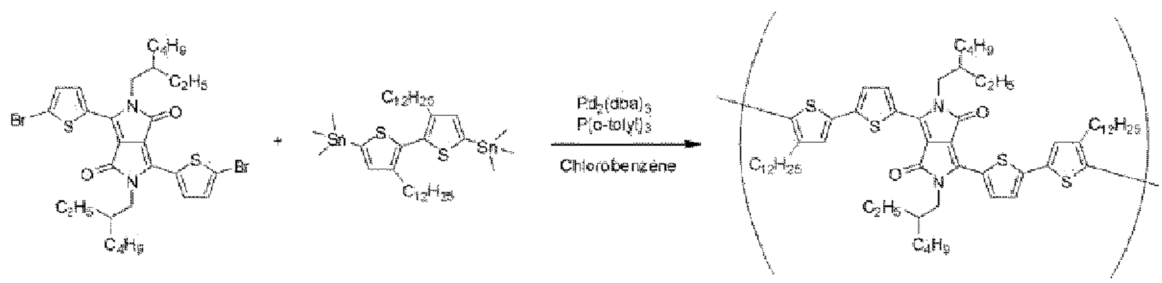


Intermediate 2

Polymer 1

(i) Intermediate 1

3,6-di(2-thienyl)-2,5-dihydropyrrolo[3,4-c]pyrrole-1,4-dione (4.0 g, 13.3 mmol), potassium carbonate (5.5 g, 39.9 mmol), and dehydrated N,N-dimethylformamide (200 mL) were mixed with each other and stirred in a nitrogen atmosphere at 120°C for 1 hour. 2-ethylhexyl bromide (7.7 g, 39.9 mmol) was added to the reaction solution, and the reaction solution was further stirred for 4 hours. The reaction solution was cooled to room temperature, and then insoluble matter was separated by filtration through celite and silica gel. The filtrate was concentrated under a reduced pressure. The crude product was purified by silica gel chromatography. As a result, an intermediate 1 (5.6 g, 10.7 mmol) was obtained.

(ii) Intermediate 2

The intermediate 1 (5.6 g, 10.7 mmol) and chloroform (200 mL) were mixed with each other, and the mixture was cooled to 0°C in a nitrogen atmosphere. N-bromosuccinimide (4.2 g, 23.5 mmol) was added to the reaction solution little by little, and the reaction solution was heated to reflux for 12 hours. The reaction solution was cooled to room temperature, and a saturated sodium hydrogen sulfite aqueous solution was added thereto to quench the reaction. The reaction product was extracted with chloroform and was concentrated under a reduced pressure. The crude product was purified by silica gel chromatography. As a result, an intermediate 2 (6.2 g, 9.1 mmol) was obtained.

(iii) Polymer 1

The intermediate 2 (200 mg, 293 μmol), 3,3'-didodecyl-5,5'-bis(trimethylstannyl)-2,2'-bithiophene (242 mg, 293 μmol), tri(o-tolyl)phosphine (7.1 mg, 23 μmol), tris(dibenzylideneacetone)dipalladium (5.4 mg, 6 μmol), and dehydrated chlorobenzene (30 mL) were mixed with each other and stirred in a nitrogen atmosphere at 130°C for 24 hours. The reaction solution was cooled to room temperature, was poured into a methanol (240 mL)/concentrated hydrochloric acid (10 mL) mixed solution, and was stirred for 2 hours. Precipitates were filtered, were cleaned with methanol, and were sequentially Soxhlet-extract with methanol, acetone, and ethyl acetate. As a result, soluble impurities were removed. Next, the reaction product was Soxhlet-extracted with chloroform, the obtained solution was concentrated under a reduced pressure, and methanol was added thereto. Precipitated solids were separated by filtration, were cleaned with methanol, and were dried in a vacuum at 80°C for 12 hours. As a result, 253 mg of the polymer 1 (yield: 82%) was obtained.

The number-average molecular weight in terms of polystyrene was $2.4\times10^4$, and the weight-average molecular weight was $6.8\times10^4$. The content of the atoms AT in the polymer 1 was 1090 ppm.

This polymer was purified using a method described in paragraph "0238: of JP2014-189721A. In the purified organic semiconductor polymer 1, the content of the atoms AT was 10 ppm.

<Synthesis Examples 2 to 13: Synthesis of Organic semiconductor polymers 2 to 13>

Organic semiconductor polymers 2 to 13 were synthesized and purified using the same method as in Synthesis Example 1, except that monomers used in Synthesis Examples 1 were changed. In the obtained organic semiconductor polymers 2 to 13 excluding the polymer 6, the content of the atoms AT was in a range of 10 to 50 ppm.

<Synthesis Example 14: Synthesis of Low Molecular Weight Organic Semiconductor Compound 14>

As a low molecular weight organic semiconductor compound 14, 2,7-Dioctyl[1]benzothieno[3,2-b][1]benzothiophene (manufactured by Sigma Aldrich, product number: 747092) was purchased and was further purified by GPC fractionation. In the purified organic semiconductor compound 14, the content of the atoms AT was 20 ppm.

<Synthesis Example 15: Synthesis of Low Molecular Weight Organic Semiconductor Compound 15>

As a low molecular weight organic semiconductor compound 15, 6,13-Bis(triisopropylsilylethynyl)pentacene (manufactured by Sigma Aldrich, product number: 716006) was purchased and was further purified by sublimation. In the purified organic semiconductor compound 15, the content of the atoms AT was 20 ppm.

[Test Example 1] Solubility Test

Regarding each of the organic semiconductor compounds obtained in Synthesis Examples, the solubility (solubility in a case where the organic semiconductor compound was heated at 60°C for 12 hours and then was cooled to room temperature (20°C); unit: mg/100 g; hereinafter, the same shall be applied) in chlorobenzene was measured (this

solubility will be referred to as "solubility X").

In addition, the organic semiconductor compound and the atoms AT were added to chlorobenzene such that the proportion of the content of the atoms AT with respect to the sum of the content of each of the organic semiconductor compounds obtained in Synthesis Examples and the content of the atoms AT was the same as the proportion (ppm) in each of organic semiconductor forming compositions 1 to 21 shown in Table 1 below. This way, in a case where the atoms AT coexisted at the above-described proportion, a solubility of the organic semiconductor compound in chlorobenzene was measured (this solubility will be referred to as "solubility Y").

A solubility improvement ratio (%) was calculated from the following expression and was evaluated based on the following evaluation standards.

$$\text{Solubility Improvement Ratio (\%)} = 100 \times (\text{Solubility Y}/\text{Solubility X})$$

<Evaluation Standards of Solubility Improvement Ratio>

A: the solubility improvement ratio was 120% or higher
B: the solubility improvement ratio was 110% or higher and lower than 120%
C: the solubility improvement ratio was 101% or higher and lower than 110%
D: the solubility improvement ratio was 100% or lower

The results are shown in the columns of the organic semiconductor film-forming compositions 1 to 21 shown in Table 1 below.

As supply sources of the atoms AT, the following supply sources were used.

Na supply source: sodium carbonate
P supply source: triphenylphosphine
Fe supply source: iron oxide
Pd supply source: tris(dibenzylideneacetone)dipalladium
Sn supply source: tributyltin chloride
B supply source: triisopropyl borate
Br supply source: bromine
I supply source: iodine

Each of the organic semiconductor film-forming compositions 1 to 21 shown in Table 1 below was prepared using a method including: adding the organic semiconductor compound and the atoms AT to chlorobenzene such that the proportion (ppm) of the content of the atoms AT with respect to the sum of the content of each of the organic semiconductor compounds and the content of the atoms AT was as shown in Table 1 below; adding the reaction solution to a glass vial such that the concentration of the organic semiconductor compound in chlorobenzene was the same as the solubility of the organic semiconductor compound in the coexistence of the atoms AT at the proportion shown in Table 1; mixing and stirring the reaction solution using a Mix rotor (manufactured by AS ONE Corporation) at 60°C for 24 hours; and cooling the reaction solution to room temperature (20°C or higher) (that is, the composition was prepared by dissolving a solubility limit amount of the organic semiconductor compound in chlorobenzene in the coexistence of the atoms AT at the proportion shown in Table 1 at 20°C).

[Manufacturing Example] Preparation of Organic Thin Film Transistor (Organic TFT) Element

A bottom gate-bottom contact type organic thin film transistor element having a structure shown in Fig. 1 was prepared.

Al for forming a gate electrode was deposited on a glass substrate (EAGLE XG: manufactured by Corning Inc.) (thickness: 50 nm). A gate insulating film-forming composition (polyvinyl phenol/melamine=1 part by mass/1 part by mass (w/w) of PGMEA (propylene glycol monomethyl ether acetate) solution (solid content concentration: 2 mass%)) was spin-coated on the gate electrode and was baked at 150°C for 60 minutes to form a gate insulating film having a thickness of 400 nm. Next, silver ink (SILVER NANOCOLLOID H-1, manufactured by Mitsubishi Materials Corporation) was drawn on the gate insulating film using an ink jet device: DMP-2831 (trade name, manufactured by Fuji Film Dimatix Inc.) in a shape of a source electrode and a drain electrode (channel length: 40 $\mu$m, channel width: 100 $\mu$m). Next, the silver ink was baked using an oven at 180°C for 30 minutes and was sintered to form the source electrode and the drain

electrode. As a result, an element substrate for evaluating TFT characteristics was obtained.

In a nitrogen glove box, each of the organic semiconductor film-forming compositions 1 to 21 shown in Table 1 below which was heated and then cooled to room temperature (20°C or higher) was spin-coated (200 rpm, 30 seconds) on the element substrate for evaluating TFT characteristics. Next, the organic semiconductor film-forming composition was dried on a hot plate at 150°C for 1 hour to form an organic semiconductor layer. This way, 10 specimens of each of bottom gate-bottom contact type organic TFT elements according to Examples 1 to 15 and Comparative Examples 1 to 6 shown in Table 1 below were obtained. In Table 1, the organic TFT elements according to Example 1, Comparative Example 1, Example 2, Comparative Example 2, Comparative Example 3, Example 3, Example 4, Comparative Example 4, Example 5, Comparative Example 5, Example 6, Comparative Example 6, and Examples 7 to 15 sequentially correspond to organic TFT elements manufactured using the organic semiconductor film-forming compositions 1 to 21, respectively.

[Test Example 2] Evaluation of Variation in Carrier mobility

Regarding each of the prepared organic TFT elements, the carrier mobility was measured in air using a semiconductor characteristic evaluation device: B2900A (trade name, manufactured by Agilent Technologies Inc.).

<Carrier Mobility>

Specifically, a voltage of -80 V was applied between the source electrode and the drain electrode of each of the organic TFT elements, a gate voltage was caused to vary in a range of +80 V to -80 V, and a carrier mobility μ was calculated using the following expression indicating a drain current $I_d$.

$$I_d=(w/2L)\mu C_i(V_g-V_{th})^2$$

In the expression, L represents the gate length, w represents the gate width, $C_i$ represents the volume of the gate insulating layer per unit area, $V_g$ represents the gate voltage, and $V_{th}$ represents a threshold voltage.

<Variation in Carrier Mobility>

Based on carrier mobilities of the 10 elements of each of Examples and Comparative Examples prepared in Manufacturing Example, a variation coefficient was calculated from the following expression, this variation coefficient was set as an index indicating the variation in carrier mobility. As the value of the variation coefficient becomes lower, the variation in mobility between the elements becomes smaller, and the manufacturing stability is improved.

Variation Coefficient (%)=100×[Standard Deviation of Carrier mobilities of 10 Elements]/[Average value of Carrier mobilities of 10 Elements]

The evaluation standards of the variation in carrier mobility are as follows. In practice, A or B is preferable, and A is more preferable.

-Evaluation Standards of Variation in Carrier mobility-

A: the variation coefficient was lower than 15%
B: the variation coefficient was 15% or higher and lower than 30%
C: the variation coefficient was 30% or higher and lower than 50%
D: the variation coefficient was 50% or higher

[Table 1]

Table 1

| | | Organic Semiconductor Film-Fonning Composition | | | | | | | | | | | |
|---|---|---|---|---|---|---|---|---|---|---|---|---|---|
| | | 1 | 2 | 3 | 4 | 5 | 6 | 7 | 8 | 9 | 10 | 11 | 12 |
| Organic Semiconductor Compound | | Polymer 1 | Polymer 1 | Polymer 2 | Polymer 2 | Polymer 2 | Polymer 3 | Polymer 4 | Polymer 4 | Polymer 5 | Polymer 5 | Polymer 6 | Polymer 6 |
| Atoms AT (ppm) | Li | - | - | - | - | - | - | - | - | - | - | - | - |
| | Na | 67 | - | 23 | - | 62 | 29 | 102 | 11 | 99 | 10 | - | - |
| | P | 128 | - | - | - | - | - | - | - | 108 | - | 14 | - |
| | K | - | - | - | - | - | - | - | - | - | - | - | - |
| | Fe | 24 | - | - | - | - | 18 | 43 | - | - | - | 88 | - |
| | Pd | 232 | 10 | 323 | 11 | 536 | 13 | 66 | - | 37 | | 150 | - |
| | Sn | 17 | - | 22 | 5 | 276 | - | 101 | - | 65 | 5 | | - |
| | B | - | - | - | - | - | 262 | - | - | - | - | 79 | - |
| | Cl | - | - | - | - | - | - | - | - | - | - | | - |
| | Br | 52 | - | - | - | 106 | 25 | - | - | 36 | - | 28 | - |
| | I | - | - | - | - | - | - | 124 | - | - | - | - | - |
| | Total | 520 | 10 | 368 | 16 | 980 | 347 | 436 | 11 | 345 | 15 | 359 | - |
| Solubility Improvement Ratio | | A | D | A | D | A | A | A | D | A | D | A | D |
| | | Organic Thin Film TFT Element | | | | | | | | | | | |
| | | Example 1 | Comparative Example 1 | Example 2 | Comparative Example 2 | Comparative Example 3 | Example 3 | Example 4 | Comparative Example 4 | Example 5 | Comparative Example 5 | Example 6 | Comparative Example 6 |
| Variation in Carrier Mobility | | A | C | A | C | D | A | A | C | B | C | B | C |
| "-" represents a detection limit or lower | | | | | | | | | | | | | |

[Table 2]

Table 1 (Continue)

| | | Organic Semiconductor Film-Forming Composition | | | | | | | | |
|---|---|---|---|---|---|---|---|---|---|---|
| | | 13 | 14 | 15 | 16 | 17 | 18 | 19 | 20 | 21 |
| Organic Semiconductor Compound | | Polymer 7 | Polymer 8 | Polymer 9 | Polymer 10 | Polymer 11 | Polymer 12 | Polymer 13 | Low Molecular Weight Compound 14 | Low Molecular Weight Compound 15 |
| AtomsAT (ppm) | Li | - | - | - | - | - | - | - | - | - |
| | Na | 150 | 66 | 8 | 248 | 175 | 137 | 116 | 106 | 36 |
| | P | 23 | - | 57 | 36 | - | 64 | 29 | - | 45 |
| | K | - | - | - | - | - | - | - | - | - |
| | Fe | 29 | - | - | - | - | - | - | - | - |
| | Pd | 157 | 211 | 39 | 15 | - | 230 | - | 34 | 318 |
| | Sn | - | 55 | - | 6 | 13 | 11 | 68 | - | 18 |
| | B | 18 | - | 280 | 228 | 115 | - | 360 | 217 | - |
| | Cl | - | - | - | - | - | - | - | - | - |
| | Br | 193 | - | 28 | - | 106 | - | 39 | 32 | - |
| | I | - | 137 | - | - | - | 146 | - | - | - |
| | Total | 570 | 469 | 412 | 533 | 409 | 588 | 612 | 389 | 417 |
| SolubilityImprovement Ratio | | B | B | C | B | B | B | C | B | C |
| | | Low Molecular Weight Compound 14 | | | | | | | | |
| | | Example 7 | Example 8 | Example 9 | Example 10 | Example 11 | Example 12 | Example 13 | Example 14 | Example 15 |
| Variation in Carrier Mobility | | B | B | B | B | B | B | B | B | B |
| "-" represents a detection limit or lower | | | | | | | | | | |

As shown in Table 1, in a case where the content of the atoms AT in the organic semiconductor layer was lower than the range defined by the present invention, the solubility of the organic semiconductor compound in the solvent was poor in the organic semiconductor film-forming composition used for forming the semiconductor layer. Therefore, the variation in the carrier mobility of the obtained organic TFT element was large (Comparative Examples 1, 2, 4, 5, and 6). The reason for this is presumed to be that, since the concentration of the organic semiconductor compound in the coating solution was not able to be sufficiently increased, thickness unevenness, film defects, or the like was likely to occur in the formed organic semiconductor layer, and the uniformity of the film deteriorated.

In addition, in a case where the content of the atoms AT in the organic semiconductor layer was higher than the range defined by the present invention, the solubility of the organic semiconductor compound in the solvent was improved in the organic semiconductor film-forming composition used for forming the semiconductor layer. However, the variation in the carrier mobility of the obtained organic TFT element was large (Comparative Example 3). The reason for this is presumed to be that excessive current leakage or the like occurred due to an excess amount of the atoms AT present in the organic semiconductor layer.

On the other hand, in each of the organic TFT elements according to Examples 1 to 15 in which the content of the atoms AT in the organic semiconductor layer was in the range defined by the present invention, the solubility of the organic semiconductor compound in the solvent was able to be effectively improved in the organic semiconductor film-forming composition used for forming the semiconductor layer, and the variation in carrier mobility was able to be effectively suppressed.

In addition, it was found that, in a case where the organic semiconductor compound used was a polymer including a structural unit represented by Formula (5), the variation in carrier mobility was able to be more effectively suppressed, and the manufacturing stability was higher.

The present invention has been described using the embodiments. However, unless specified otherwise, any of the details of the above description is not intended to limit the present invention and can be construed in a broad sense within a range not departing from the concept and scope of the present invention disclosed in the accompanying claims.

The present application claims priority based on JP2016-077035 filed on April 7, 2016, the entire content of which is incorporated herein by reference.

Explanation of References

10: substrate
20: gate electrode
30: gate insulating layer (film)
40: source electrode
42: drain electrode
50: organic semiconductor layer (film)
60: sealing layer
100, 200: organic thin film transistor element

## Claims

**1.** An organic thin film transistor element comprising:

an organic semiconductor layer that includes an organic semiconductor compound,
wherein a content of one kind or two or more kinds of atoms selected from the group consisting of Li, Na, P, K, Fe, Pd, Sn, B, Cl, Br, and I in the organic semiconductor layer is 300 to 700 ppm.

**2.** The organic thin film transistor element according to claim 1,
wherein the organic semiconductor compound is an organic semiconductor polymer including a structural unit represented by the following Formula (1),

$$-\!\!\left[ D\text{-}A \right]\!\!- \qquad (1)$$

in Formula (1), D represents a group having an aromatic heterocycle having a monocyclic structure or a fused polycyclic structure which has at least one atom selected from the group consisting of a nitrogen atom, an

oxygen atom, a sulfur atom, and a selenium atom as a ring-constituting atom, or a group having a fused polycyclic aromatic hydrocarbon ring, and

A represents a group having a structure represented by any one of the following Formulae (A-1) to (A-9),

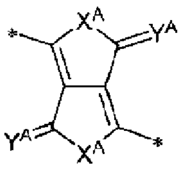

(A-1)

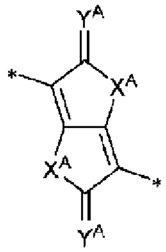

(A-2)

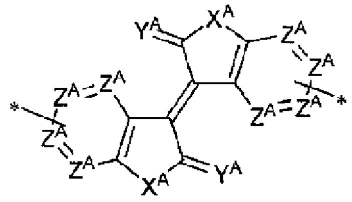

(A-3)

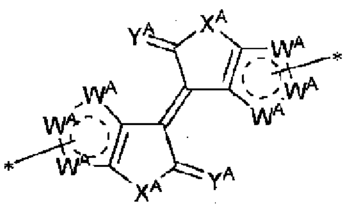

(A-4)

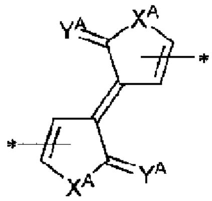

(A-5)

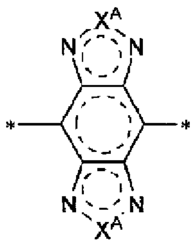

(A-6)

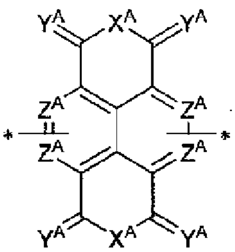

(A-7)

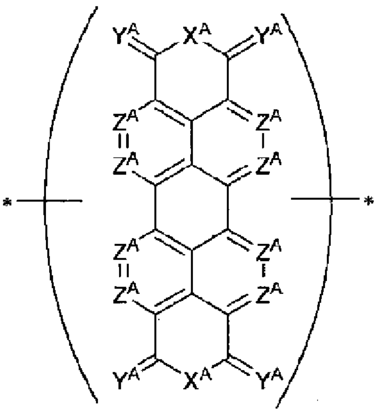

(A-8)

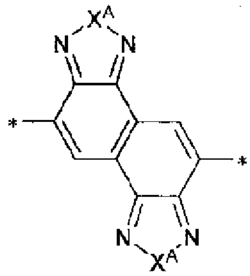

(A-9)

in Formulae (A-1) to (A-9),

$X^A$ represents an oxygen atom, a sulfur atom, a selenium atom, or $NR^X$,
$R^X$ represents an alkyl group or a group represented by the following Formula (1-1),
$Y^A$ represents an oxygen atom or a sulfur atom,
$Z^A$ represents $CR^{A2}$ or a nitrogen atom,
$W^A$ represents $C(R^{A2})_2$, $NR^{A1}$, a nitrogen atom, $CR^{A2}$, an oxygen atom, a sulfur atom, or a selenium atom,
$R^{A1}$ represents an alkyl group, a group represented by the following Formula (1-1), or a single bond,
$R^{A2}$ represents a hydrogen atom, a halogen atom, an alkyl group, or a single bond, and
* represents a binding site for incorporation into A in Formula (1), and

$$*-L_a-Ar(-L_b)_l \qquad (1-1)$$

in Formula (1-1),

$L_a$ represents an alkylene group having 1 to 20 carbon atoms,

Ar represents an aromatic heterocyclic group or an aromatic hydrocarbon group having 6 to 18 carbon atoms,
$L_b$ represents an alkyl group having 1 to 100 carbon atoms,
l represents an integer of 1 to 5, and
* represents a binding site.

**3.** The organic thin film transistor element according to claim 2,
wherein D in Formula (1) represents a group represented by the following Formula (D-1),

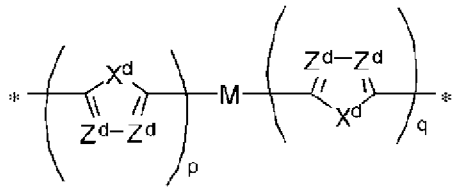
(D-1)

in Formula (D-1),

$X^d$ represents an oxygen atom, a sulfur atom, a selenium atom, or $NR^{D1}$,
$R^{D1}$ represents an organic group,
$Z^d$ represents a nitrogen atom or $CR^{D2}$,
$R^{D2}$ represents a hydrogen atom or an organic group,
M represents a single bond, an aromatic heterocyclic group, an aromatic hydrocarbon group, an alkenylene group, or an alkynylene group, or a divalent group including a combination of two or more selected from the group consisting of an aromatic heterocyclic group, an aromatic hydrocarbon group, an alkenylene group, and an alkynylene group,
p and q represent an integer of 0 to 4, and
* represents a binding site for incorporation into a structural unit represented by Formula (1).

**4.** The organic thin film transistor element according to claim 2 or 3,
wherein the structural unit represented by Formula (1) is a structural unit represented by any one of the following Formulae (2) to (4),

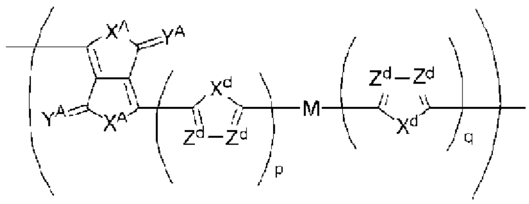
(2)

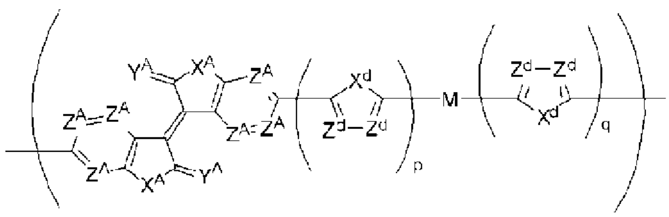
(3)

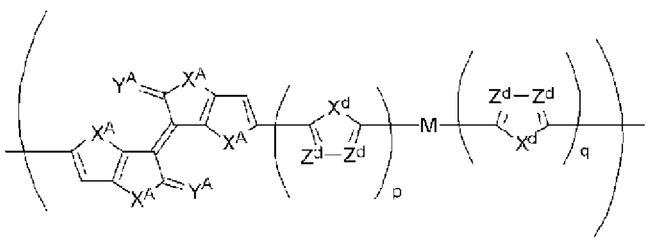
(4)

in Formulae (2) to (4),

$X^A$, $Y^A$, and $Z^A$ have the same definitions as $X^A$, $Y^A$, and $Z^A$ described regarding Formulae (A-1) to (A-9), respectively, and
$X^d$, $Z^d$, M, p, and q have the same definitions as $X^d$, $Z^d$, M, p, and q described regarding Formula (D-1), respectively.

**5.** The organic thin film transistor element according to claim 2 or 3,
wherein the structural unit represented by Formula (1) is a structural unit represented by the following Formula (5),

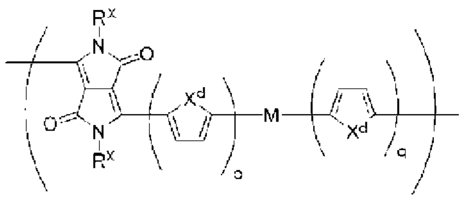

(5)

in Formula (5),

$R^X$ has the same definition as $R^X$ described regarding Formulae (A-1) to (A-9), and
$X^d$, M, p, and q have the same definitions as $X^d$, M, p, and q described regarding Formula (D-1), respectively.

**6.** The organic thin film transistor element according to any one of claims 1 to 5,
wherein a content of one kind or two or more kinds of atoms selected from the group consisting of Na, P, Fe, Pd, Sn, B, Br, and I in the organic semiconductor layer is 300 to 700 ppm.

**7.** An organic semiconductor film-forming composition comprising:

an organic semiconductor compound; and
one kind or two or more kinds of atoms selected from the group consisting of Li, Na, P, K, Fe, Pd, Sn, B, Cl, Br, and I, wherein a proportion of a content of the one kind or two or more kinds of atoms selected from the group consisting of Li, Na, P, K, Fe, Pd, Sn, B, Cl, Br, and I with respect to the sum of a content of the organic semiconductor compound and the content of the one kind or two or more kinds of atoms selected from the group consisting of Li, Na, P, K, Fe, Pd, Sn, B, Cl, Br, and I is 300 to 700 ppm.

**8.** The organic semiconductor film-forming composition according to claim 7,
wherein the organic semiconductor compound is an organic semiconductor polymer including a structural unit represented by the following Formula (1),

$$\{D\text{-}A\} \qquad (1)$$

in Formula (1), D represents a group having an aromatic heterocycle having a monocyclic structure or a fused polycyclic structure which has at least one atom selected from the group consisting of a nitrogen atom, an oxygen atom, a sulfur atom, and a selenium atom as a ring-constituting atom, or a group having a fused polycyclic aromatic hydrocarbon ring, and
A represents a group having a structure represented by any one of the following Formulae (A-1) to (A-9),

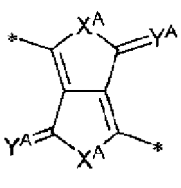

(A-1)

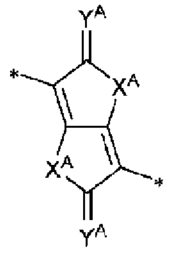

(A-2)

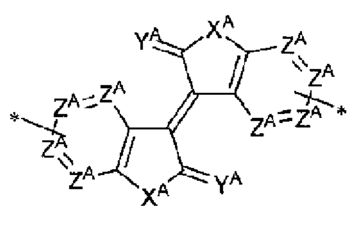

(A-3)

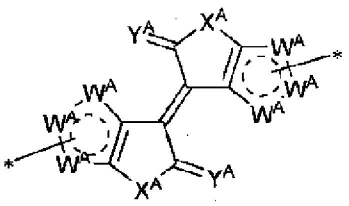

(A-4)

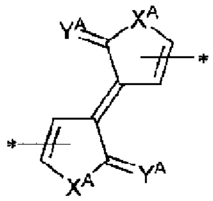

(A-5)

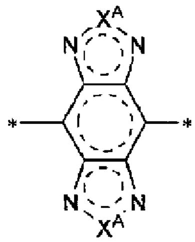

(A-6)

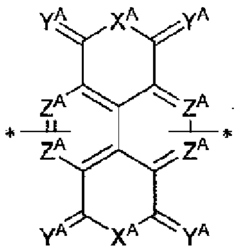

(A-7)

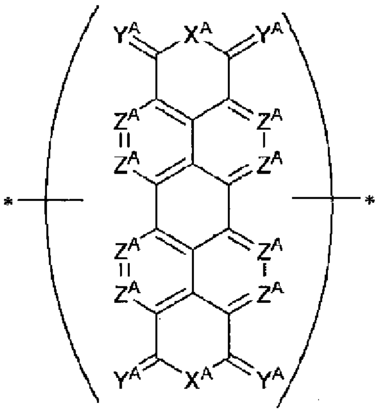

(A-8)

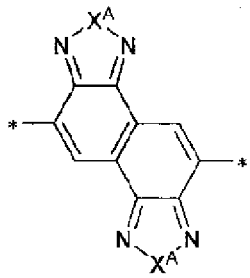

(A-9)

in Formulae (A-1) to (A-9),

$X^A$ represents an oxygen atom, a sulfur atom, a selenium atom, or $NR^X$,
$R^X$ represents an alkyl group or a group represented by the following Formula (1-1),
$Y^A$ represents an oxygen atom or a sulfur atom,
$Z^A$ represents $CR^{A2}$ or a nitrogen atom,
$W^A$ represents $C(R^{A2})_2$, $NR^{A1}$, a nitrogen atom, $CR^{A2}$, an oxygen atom, a sulfur atom, or a selenium atom,
$R^{A1}$ represents an alkyl group, a group represented by the following Formula (1-1), or a single bond,
$R^{A2}$ represents a hydrogen atom, a halogen atom, an alkyl group, or a single bond, and
* represents a binding site for incorporation into A in Formula (1), and

$$*\text{-}L_a\text{-}Ar(L_b)_l \qquad (1\text{-}1)$$

in Formula (1-1),

$L_a$ represents an alkylene group having 1 to 20 carbon atoms,
Ar represents an aromatic heterocyclic group or an aromatic hydrocarbon group having 6 to 18 carbon atoms,
$L_b$ represents an alkyl group having 1 to 100 carbon atoms,
l represents an integer of 1 to 5, and
* represents a binding site.

**9.** The organic semiconductor film-forming composition according to claim 7 or 8, further comprising: a solvent.

**10.** A method of forming an organic semiconductor film comprising: forming an organic semiconductor film using the organic semiconductor film-forming composition according to any one of claims 7 to 9.

**11.** An organic semiconductor film comprising:

an organic semiconductor compound; and
at least one atom selected from the group consisting of Li, Na, P, K, Fe, Pd, Sn, B, Cl, Br, and I,
wherein a content of the at least one atom selected from the group consisting of Li, Na, P, K, Fe, Pd, Sn, B, Cl, Br, and I in the organic semiconductor film is 300 to 700 ppm.

**Amended claims under Art. 19.1 PCT**

**1.** An organic thin film transistor element comprising:

an organic semiconductor layer that includes an organic semiconductor compound,
wherein a content of one kind or two or more kinds of atoms selected from the group consisting of Li, Na, P, K, Fe, Pd, Sn, B, Cl, Br, and I in the organic semiconductor layer is 300 to 700 ppm; and
wherein the organic semiconductor compound is an organic semiconductor polymer including a structural unit represented by the following Formula (1),

$$\left( D\text{-}A \right) \qquad (1)$$

in Formula (1), D represents a group having an aromatic heterocycle having a monocyclic structure or a fused polycyclic structure which has at least one atom selected from the group consisting of a nitrogen atom, an oxygen atom, a sulfur atom, and a selenium atom as a ring-constituting atom, or a group having a fused polycyclic aromatic hydrocarbon ring, and
A represents a group having a structure represented by any one of the following Formulae (A-1) to (A-9),

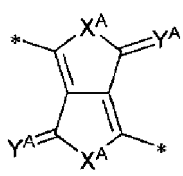
(A-1)

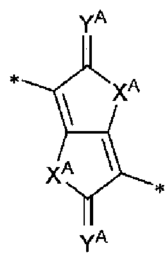
(A-2)

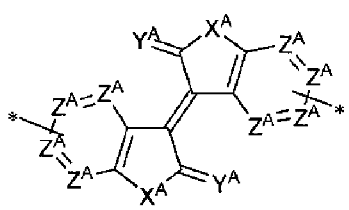
(A-3)

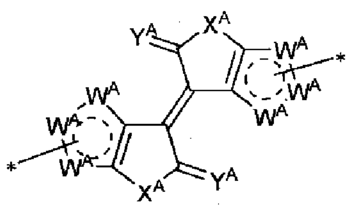
(A-4)

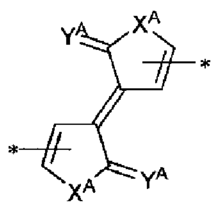
(A-5)

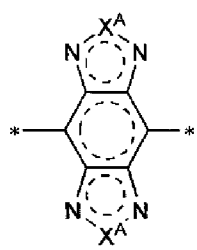
(A-6)

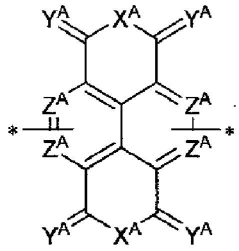

(A-7)

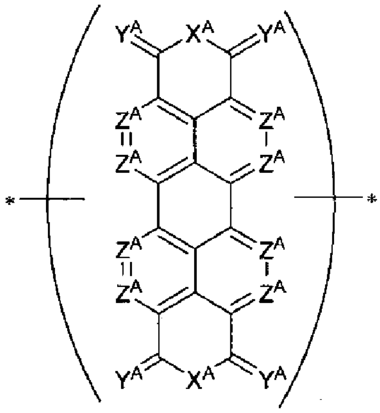

(A-8)

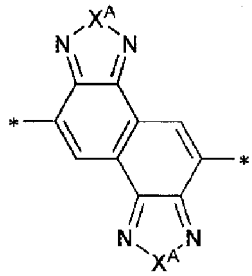

(A-9)

in Formulae (A-1) to (A-9),

$X^A$ represents an oxygen atom, a sulfur atom, a selenium atom, or $NR^X$,
$R^X$ represents an alkyl group or a group represented by the following Formula (1-1),
$Y^A$ represents an oxygen atom or a sulfur atom,
$Z^A$ represents $CR^{A2}$ or a nitrogen atom,
$W^A$ represents $C(R^{A2})_2$, $NR^{A1}$, a nitrogen atom, $CR^{A2}$, an oxygen atom, a sulfur atom, or a selenium atom,
$R^{A1}$ represents an alkyl group, a group represented by the following Formula (1-1), or a single bond,
$R^{A2}$ represents a hydrogen atom, a halogen atom, an alkyl group, or a single bond, and
* represents a binding site for incorporation into A in Formula (1), and

$$*-L_a-Ar-(L_b)_l \qquad (1-1)$$

in Formula (1-1),

$L_a$ represents an alkylene group having 1 to 20 carbon atoms,
Ar represents an aromatic heterocyclic group or an aromatic hydrocarbon group having 6 to 18 carbon atoms,
$L_b$ represents an alkyl group having 1 to 100 carbon atoms,
l represents an integer of 1 to 5, and
* represents a binding site.

**2.** (Deleted)

**3.** The organic thin film transistor element according to claim 1,
wherein D in Formula (1) represents a group represented by the following Formula (D-1),

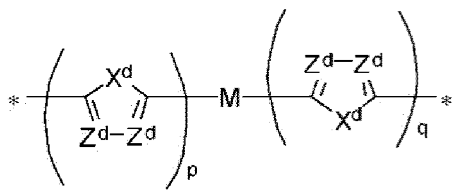 (D-1)

in Formula (D-1),

$X^d$ represents an oxygen atom, a sulfur atom, a selenium atom, or $NR^{D1}$,
$R^{D1}$ represents an organic group,
$Z^d$ represents a nitrogen atom or $CR^{D2}$,
$R^{D2}$ represents a hydrogen atom or an organic group,

M represents a single bond, an aromatic heterocyclic group, an aromatic hydrocarbon group, an alkenylene group, or an alkynylene group, or a divalent group including a combination of two or more selected from the group consisting of an aromatic heterocyclic group, an aromatic hydrocarbon group, an alkenylene group, and an alkynylene group,
p and q represent an integer of 0 to 4, and
* represents a binding site for incorporation into a structural unit represented by Formula (1).

**4.** The organic thin film transistor element according to claim 1 or 3,
wherein the structural unit represented by Formula (1) is a structural unit represented by any one of the following Formulae (2) to (4),

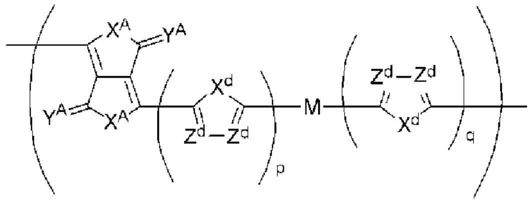
(2)

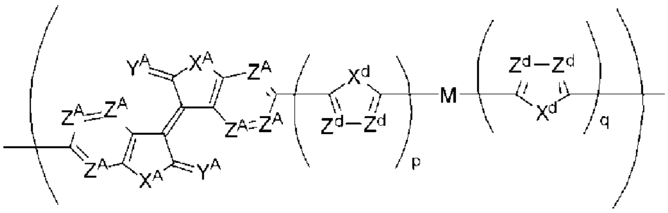
(3)

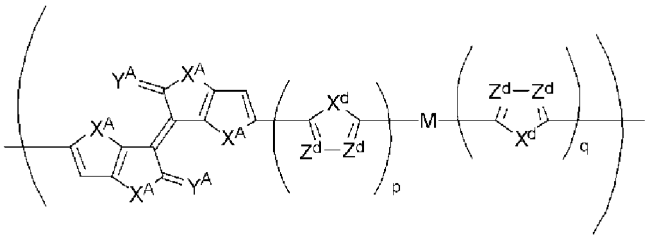
(4)

in Formulae (2) to (4),

$X^A$, $Y^A$, and $Z^A$ have the same definitions as $X^A$, $Y^A$, and $Z^A$ described regarding Formulae (A-1) to (A-9), respectively, and
$X^d$, $Z^d$, M, p, and q have the same definitions as $X^d$, $Z^d$, M, p, and q described regarding Formula (D-1), respectively.

**5.** The organic thin film transistor element according to claim 1 or 3,
wherein the structural unit represented by Formula (1) is a structural unit represented by the following Formula (5),

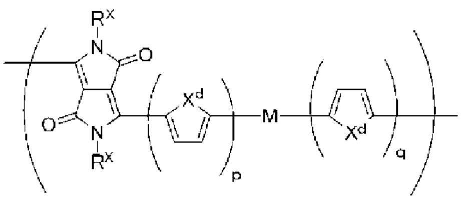
(5)

in Formula (5),

$R^X$ has the same definition as $R^X$ described regarding Formulae (A-1) to (A-9), and
$X^d$, M, p, and q have the same definitions as $X^d$, M, p, and q described regarding Formula (D-1), respectively.

**6.** The organic thin film transistor element according to any one of claims 1 and 3 to 5, wherein a content of one kind or two or more kinds of atoms selected from the group consisting of Na, P, Fe, Pd, Sn, B, Br, and I in the organic semiconductor layer is 300 to 700 ppm.

**7.** An organic semiconductor film-forming composition comprising:

an organic semiconductor compound; and
one kind or two or more kinds of atoms selected from the group consisting of Li, Na, P, K, Fe, Pd, Sn, B, Cl, Br, and I,
wherein a proportion of a content of the one kind or two or more kinds of atoms selected from the group consisting of Li, Na, P, K, Fe, Pd, Sn, B, Cl, Br, and I with respect to the sum of a content of the organic semiconductor compound and the content of the one kind or two or more kinds of atoms selected from the group consisting of Li, Na, P, K, Fe, Pd, Sn, B, Cl, Br, and I is 300 to 700 ppm; and
wherein the organic semiconductor compound is an organic semiconductor polymer including a structural unit represented by the following Formula (1),

$$\{D\text{-}A\} \qquad (1)$$

in Formula (1), D represents a group having an aromatic heterocycle having a monocyclic structure or a fused polycyclic structure which has at least one atom selected from the group consisting of a nitrogen atom, an oxygen atom, a sulfur atom, and a selenium atom as a ring-constituting atom, or a group having a fused polycyclic aromatic hydrocarbon ring, and
A represents a group having a structure represented by any one of the following Formulae (A-1) to (A-9),

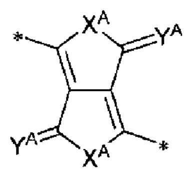
(A-1)

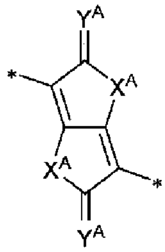
(A-2)

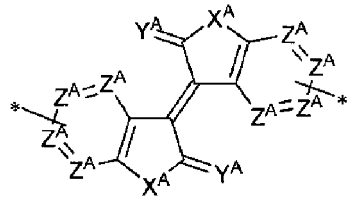
(A-3)

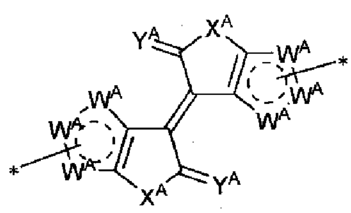
(A-4)

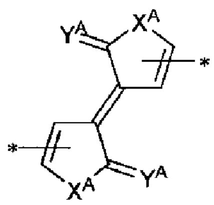
(A-5)

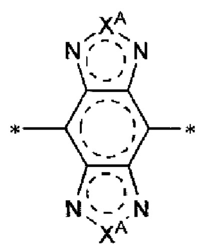
(A-6)

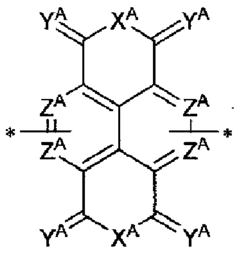

(A-7)

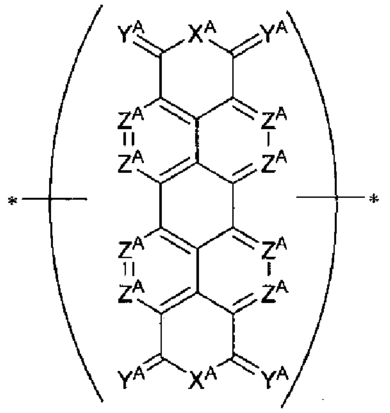

(A-8)

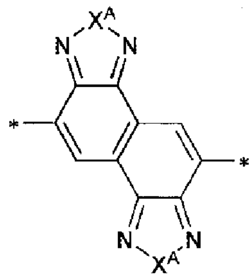

(A-9)

in Formulae (A-1) to (A-9),

$X^A$ represents an oxygen atom, a sulfur atom, a selenium atom, or $NR^X$,
$R^X$ represents an alkyl group or a group represented by the following Formula (1-1),
$Y^A$ represents an oxygen atom or a sulfur atom,
$Z^A$ represents $CR^{A2}$ or a nitrogen atom,
$W^A$ represents $C(R^{A2})_2$, $NR^{A1}$, a nitrogen atom, $CR^{A2}$, an oxygen atom, a sulfur atom, or a selenium atom,
$R^{A1}$ represents an alkyl group, a group represented by the following Formula (1-1), or a single bond,
$R^{A2}$ represents a hydrogen atom, a halogen atom, an alkyl group, or a single bond, and
* represents a binding site for incorporation into A in Formula (1), and

$$*\text{-}L_a\text{-}Ar\text{-}(L_b)_l \qquad (1\text{-}1)$$

in Formula (1-1),

$L_a$ represents an alkylene group having 1 to 20 carbon atoms,
Ar represents an aromatic heterocyclic group or an aromatic hydrocarbon group having 6 to 18 carbon atoms,
$L_b$ represents an alkyl group having 1 to 100 carbon atoms,
l represents an integer of 1 to 5, and
* represents a binding site.

**8.** (Deleted)

**9.** The organic semiconductor film-forming composition according to claim 6, further comprising: a solvent.

**10.** A method of forming an organic semiconductor film comprising: forming an organic semiconductor film using the organic semiconductor film-forming composition according to claim 6 or 7.

**11.** An organic semiconductor film comprising:

an organic semiconductor compound; and
at least one atom selected from the group consisting of Li, Na, P, K, Fe, Pd, Sn, B, Cl, Br, and I,
wherein a content of the at least one atom selected from the group consisting of Li, Na, P, K, Fe, Pd, Sn, B, Cl, Br, and I in the organic semiconductor film is 300 to 700 ppm; and
wherein the organic semiconductor compound is an organic semiconductor polymer including a structural unit represented by the following Formula (1),

$$\text{-}(D\text{-}A)\text{-} \qquad (1)$$

in Formula (1), D represents a group having an aromatic heterocycle having a monocyclic structure or a fused polycyclic structure which has at least one atom selected from the group consisting of a nitrogen atom, an oxygen atom, a sulfur atom, and a selenium atom as a ring-constituting atom, or a group having a fused polycyclic aromatic hydrocarbon ring, and

A represents a group having a structure represented by any one of the following Formulae (A-1) to (A-9),

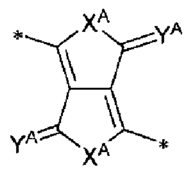

(A-1)

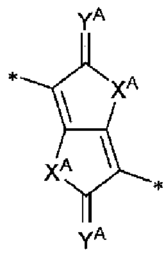

(A-2)

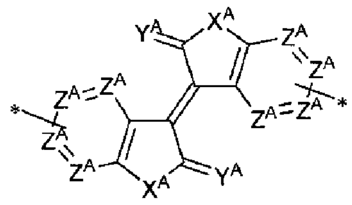

(A-3)

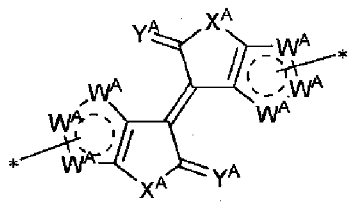

(A-4)

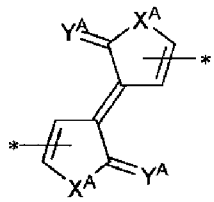

(A-5)

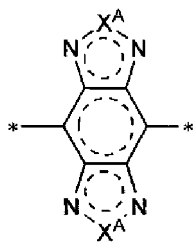

(A-6)

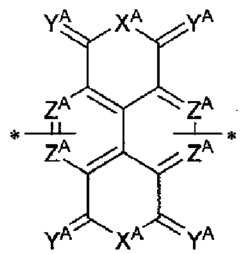

(A-7)

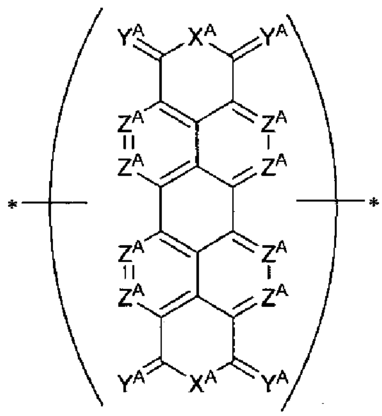

(A-8)

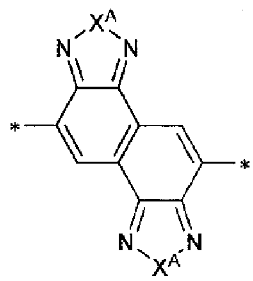

(A-9)

in Formulae (A-1) to (A-9),

$X^A$ represents an oxygen atom, a sulfur atom, a selenium atom, or $NR^X$,
$R^X$ represents an alkyl group or a group represented by the following Formula (1-1),
$Y^A$ represents an oxygen atom or a sulfur atom,
$Z^A$ represents $CR^{A2}$ or a nitrogen atom,
$W^A$ represents $C(R^{A2})_2$, $NR^{A1}$, a nitrogen atom, $CR^{A2}$, an oxygen atom, a sulfur atom, or a selenium atom,
$R^{A1}$ represents an alkyl group, a group represented by the following Formula (1-1), or a single bond,
$R^{A2}$ represents a hydrogen atom, a halogen atom, an alkyl group, or a single bond, and
* represents a binding site for incorporation into A in Formula (1), and

$$*\text{-}L_a\text{-}Ar(L_b)_l \qquad (1\text{-}1)$$

in Formula (1-1),

$L_a$ represents an alkylene group having 1 to 20 carbon atoms,
Ar represents an aromatic heterocyclic group or an aromatic hydrocarbon group having 6 to 18 carbon atoms,
$L_b$ represents an alkyl group having 1 to 100 carbon atoms,
l represents an integer of 1 to 5, and
* represents a binding site.

FIG. 1

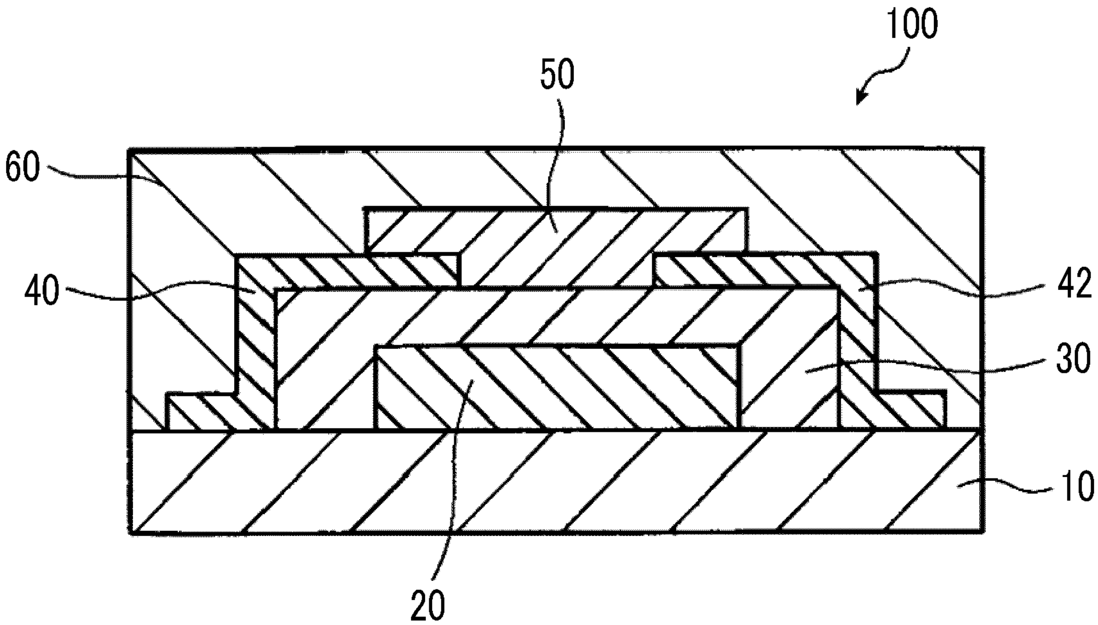


FIG. 2

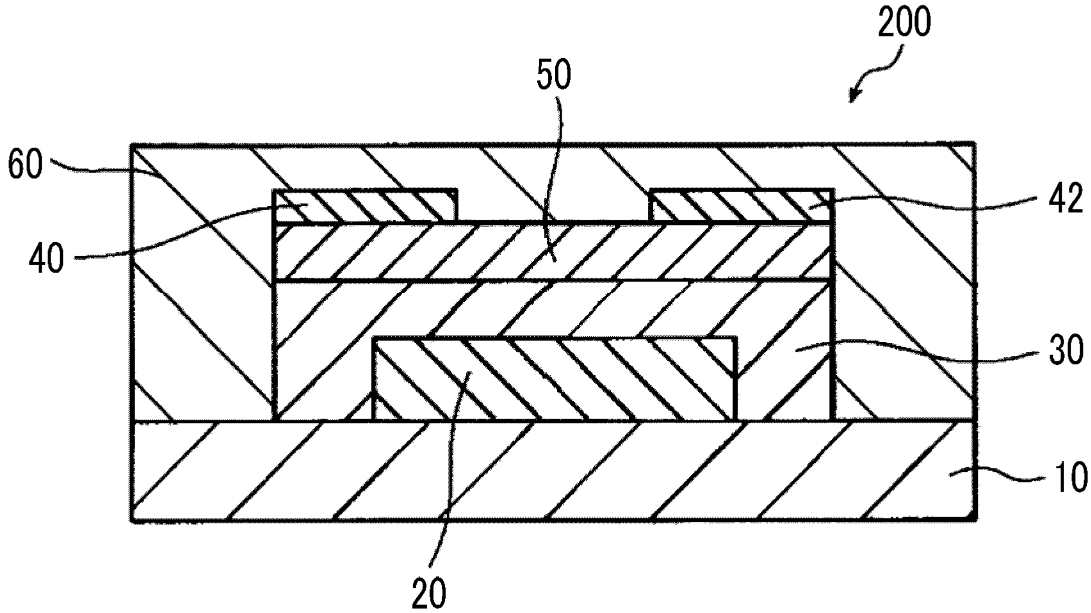

## INTERNATIONAL SEARCH REPORT

International application No. PCT/JP2017/013390

A. CLASSIFICATION OF SUBJECT MATTER
*H01L51/05*(2006.01)i, *C08G61/12*(2006.01)i, *H01L29/786*(2006.01)i, *H01L51/30*(2006.01)i

According to International Patent Classification (IPC) or to both national classification and IPC

B. FIELDS SEARCHED

Minimum documentation searched (classification system followed by classification symbols)
H01L51/05, C08G61/12, H01L29/786, H01L51/30

Documentation searched other than minimum documentation to the extent that such documents are included in the fields searched
Jitsuyo Shinan Koho 1922-1996 Jitsuyo Shinan Toroku Koho 1996-2017
Kokai Jitsuyo Shinan Koho 1971-2017 Toroku Jitsuyo Shinan Koho 1994-2017

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2012-224618 A (Fujifilm Corp.), 15 November 2012 (15.11.2012), paragraphs [0020] to [0472] & US 2014/0042411 A1 paragraphs [0069] to [0679] & WO 2012/137741 A1 & KR 10-2014-0015448 A | 1,6-7,9-11 |
| X | JP 2007-287961 A (Konica Minolta Holdings, Inc.), 01 November 2007 (01.11.2007), paragraphs [0028] to [0122] (Family: none) | 1,6-7,9-11 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 29 May 2017 (29.05.17) | 06 June 2017 (06.06.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No. PCT/JP2017/013390

C (Continuation). DOCUMENTS CONSIDERED TO BE RELEVANT

| Category* | Citation of document, with indication, where appropriate, of the relevant passages | Relevant to claim No. |
|---|---|---|
| A | JP 2012-167242 A (Mitsubishi Chemical Corp.), 06 September 2012 (06.09.2012), paragraphs [0013] to [0482] & US 2013/0333758 A1 paragraphs [0026] to [0632] & WO 2012/102390 A1 & EP 2669966 A1 & CN 103380506 A | 1-11 |
| A | JP 2012-506928 A (BASF SE), 22 March 2012 (22.03.2012), paragraphs [0011] to [0200] & US 2011/0240981 A1 paragraphs [0011] to [0254] & WO 2010/049321 A1 & TW 201026739 A1 & KR 10-2011-0091711 A & CN 102272192 A | 1-11 |
| A | JP 2012-229394 A (Sumitomo Chemical Co., Ltd.), 22 November 2012 (22.11.2012), paragraphs [0012] to [0123] & WO 2012/050070 A1 & TW 201226432 A1 | 1-11 |
| A | WO 2015/076171 A1 (Daicel Corp.), 28 May 2015 (28.05.2015), paragraphs [0011] to [0104] & US 2016/0293849 A1 paragraphs [0020] to [0135] & DE 112014005330 T5 & CN 105659404 A & KR 10-2016-0088328 A & TW 201527428 A | 1-11 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004083650 A
- JP 2003347624 A
- US 20150218304 A
- JP 2013214649 A
- JP 2011186069 A
- JP 2010285518 A
- JP 2012163946 A
- JP 2005354012 A
- JP 2006303465 A
- JP 2013207085 A
- WO 2014175351 A
- JP 5480510 B
- JP 2010527327 A
- JP 2007516315 A
- JP 2014515043 A
- JP 2014507488 A
- JP 2011501451 A
- JP 2010018790 A
- WO 2012174561 A
- JP 2011514399 A
- JP 2011514913 A
- JP 2014189721 A
- JP 2016077035 A